# EUROPEAN PATENT APPLICATION

(11) **EP 4 642 190 A1**
(43) Date of publication of application: **29.10.2025**
(21) Application number: 25172002.5
(22) Date of filing: 23.04.2025
(51) Int. Cl.: H10D 86/40, H10K 59/124

(54) **DISPLAY DEVICE AND METHOD FOR MANUFACTURING THE SAME, AND ELECTRONIC DEVICE INCLUDING DISPLAY DEVICE**

(30) Priority: 24.04.2024 KR 20240054423
(71) Applicant: Samsung Display Co., Ltd., Yongin-si, Gyeonggi-do 17113 (KR)
(72) Inventor: KO, Seung Cheol, Yongin-si (KR); LEE, Young Suk, Yongin-si (KR)
(74) Representative: Marks & Clerk LLP

(57) **Abstract**

A display device includes a substrate, and a circuit layer including circuit elements and wires disposed on the substrate. The circuit layer includes a lower conductive layer disposed on the substrate and including a first pattern, a first insulating layer disposed on the lower conductive layer, including a groove at a portion including a portion of the first insulating layer covering the first pattern, and having a reduced thickness in the portion of the first insulating layer, an upper conductive layer disposed on the first insulating layer, and including a second pattern disposed on the groove, and a second insulating layer covering the upper conductive layer.

## Description

### BACKGROUND

### 1. Technical Field

The present invention relates to a display device, and in particular to a display device capable of preventing pattern defects in a conductive layer and a method for manufacturing the same, and an electronic device including the display device.

### 2. Description of the Related Art

With the advance of an information-oriented society, more and more demands are placed on display devices for displaying images in various ways. Along with this trend, various types of display devices including a light-emitting display device are being developed.

### SUMMARY

Aspects of the present invention provide a display device that is capable of preventing pattern defects in a conductive layer and a method for manufacturing the same, and an electronic device including the display device.

However, aspects of the invention are not restricted to the embodiments disclosed herein. The above and other aspects of the present invention will become more apparent to one of ordinary skill in the art to which the invention pertains by referencing the detailed description of the invention given below.

According to an aspect of the invention, there is provided a display device including, a substrate, and a circuit layer including circuit elements and wires disposed on the substrate, and the circuit layer includes a lower conductive layer disposed on the substrate and including a first pattern, a first insulating layer disposed on the lower conductive layer, including a groove disposed on a portion of the first insulating layer including a first portion having a reduced thickness and that is covering the first pattern, an upper conductive layer disposed on the first insulating layer, and including a second pattern disposed on the groove, and a second insulating layer covering the upper conductive layer.

In an embodiment, the first insulating layer may be a single-layer inorganic insulating layer or a multilayer inorganic insulating layer.

In an embodiment, portions of the first insulating layer may have stepped portions corresponding to patterns of the lower conductive layer.

In an embodiment, a depth of the groove may range from about 200 Å to about 800 Å.

In an embodiment, the first insulating layer between the first pattern and the second pattern may have a thickness of about 500 Å to about 1000 Å.

In an embodiment, the lower conductive layer may include a plurality of conductive layers including at least one electrode among electrodes included in the circuit elements and at least one wire among the wires.

In an embodiment, the upper conductive layer may include at least one conductive layer disposed on the plurality of conductive layers.

In an embodiment, the upper conductive layer may be a conductive layer that is disposed at an uppermost portion among the conductive layers included in the circuit layer.

In an embodiment, the display device may further include a light-emitting element layer disposed on the circuit layer, wherein the light-emitting element layer includes a light-emitting element electrically connected to the circuit elements.

According to an embodiment, a display device is provided and includes, a substrate, and a circuit layer including circuit elements and wires disposed on the substrate. The circuit layer may include a lower conductive layer disposed on the substrate, and may include a first pattern, a first insulating layer including a first inorganic insulating layer disposed on the lower conductive layer and a second inorganic insulating layer disposed on the first inorganic insulating layer, wherein the second inorganic insulating layer is removed from a portion of the first inorganic insulating layer that is overlapping the first pattern, an upper conductive layer including a second pattern disposed on a portion of the first insulating layer including a portion from which the second inorganic insulating layer has been removed, and a second insulating layer covering the upper conductive layer.

In an embodiment, the first inorganic insulating layer and the second inorganic insulating layer may contain different inorganic insulating materials.

In an embodiment, the first inorganic insulating layer may contain silicon nitride, and the second inorganic insulating layer may contain silicon oxide.

In an embodiment, the first inorganic insulating layer may be disposed at a highest level above the first pattern.

In an embodiment, the display device may further include a light-emitting element layer disposed on the circuit layer, the light-emitting element layer including a light-emitting element electrically connected to the circuit elements.

According to an embodiment, a method for manufacturing a display device is provided and includes forming, on a substrate, a lower conductive layer including a first pattern and a first insulating layer covering the lower conductive layer, planarizing the first insulating layer by etching a portion of the first insulating layer overlapping the first pattern to a predetermined thickness, and forming, on the first insulating layer, an upper conductive layer including a second pattern disposed on the portion of the first insulating layer that overlaps the first pattern.

In an embodiment, the planarizing of the first insulating layer may include dry etching the portion of the first insulating layer using at least one mask pattern.

In an embodiment, the planarizing of the first insulating layer may include etching a primary stepped portion of the first insulating layer in which the first insulating layer protrudes to a highest level above the first pattern, and forming a groove in the first insulating layer by over-etching a secondary stepped portion of the first insulating layer in which the first insulating layer extends to a highest level in a state where the primary stepped portion is etched.

In an embodiment, the planarizing of the first insulating layer may include forming a groove in the first insulating layer by over-etching the portion of the first insulating layer above the first pattern.

In an embodiment, the forming of the first insulating layer may include sequentially forming a first inorganic insulating layer and a second inorganic insulating layer containing different materials from the first inorganic insulating layer onto the lower conductive layer, and wherein the planarizing of the first insulating layer includes etching the second inorganic insulating layer on the portion of the first insulating layer.

In an embodiment, the method may further include forming a second insulating layer on the upper conductive layer, and forming a light-emitting element layer including a light-emitting element on the second insulating layer.

According to an aspect of the invention, there is provided an electronic device including a display device, the display device including, a substrate, and a circuit layer including circuit elements and wires disposed on the substrate, and the circuit layer includes a lower conductive layer disposed on the substrate and including a first pattern, a first insulating layer disposed on the lower conductive layer, including a groove disposed at a portion of the first insulating layer including a first portion having a reduced thickness and that is covering the first pattern, an upper conductive layer disposed on the first insulating layer, and including a second pattern disposed on the groove, and a second insulating layer covering the upper conductive layer.

According to some embodiments, the pattern defects in the conductive layer, such as disconnection or short circuit, may be prevented. For example, a portion, which includes a primary stepped portion, of an insulating layer covering the lower patterns may be planarized to reduce the thickness, so that disconnection defects in the upper patterns disposed on the insulating layer may be prevented.

Additionally, according to some embodiments, the insulating layer may be appropriately etched and planarized by an etching process using a mask pattern. Accordingly, it is possible to prevent the insulating layer from being excessively etched or polished or foreign matter from interfering during a planarization process of the insulating layer. As a result, the electrical stability of the upper and lower patterns disposed in the upper and lower portions of the insulating layer may be improved, and short circuit defects may be prevented.

However, effects according to the invention are not limited to those of the above examples and various other effects are incorporated herein.

At least some of the above and other features of the invention are set out in the claims.

### BRIEF DESCRIPTION OF THE DRAWINGS

The above and other aspects and features of the invention will become more apparent by describing in detail embodiments thereof with reference to the attached drawings, in which:
FIG. 1 is a perspective view of a display device, according to an embodiment;
FIG. 2 is an equivalent circuit diagram of a pixel, according to an embodiment;
FIG. 3 is a cross-sectional view of a display device, according to an embodiment;
FIG. 4 is a cross-sectional view of a display device, according to an embodiment;
FIG. 5 is a cross-sectional view of a display device, according to an embodiment;
FIG. 6 is a cross-sectional view of an insulating layer illustrating a method for manufacturing the display device, according to an embodiment;
FIG. 7 is a cross-sectional view of an insulating layer illustrating a method for manufacturing the display device, according to an embodiment;
FIG. 8 is a cross-sectional view of an insulating layer illustrating a method for manufacturing the display device, according to an embodiment;
FIG. 9 is a cross-sectional view of an insulating layer illustrating a method for manufacturing the display device, according to an embodiment;
FIG. 10 is a cross-sectional view of an insulating layer illustrating a method for manufacturing the display device, according to an embodiment;
FIG. 11 is a cross-sectional view of an insulating layer illustrating a method for manufacturing the display device, according to an embodiment;
FIG. 12 is a cross-sectional view of an insulating layer illustrating a method for manufacturing the display device, according to an embodiment;
FIG. 13 is a cross-sectional view of an insulating layer illustrating a method for manufacturing the display device, according to an embodiment;
FIG. 14 is a cross-sectional view of an insulating layer illustrating a method for manufacturing the display device, according to an embodiment;
FIG. 15 is a cross-sectional view of an insulating layer illustrating a method for manufacturing the display device, according to an embodiment;
FIG. 16 is a cross-sectional view of an insulating layer illustrating a method for manufacturing the display device, according to an embodiment;
FIG. 17 is a cross-sectional view of an insulating layer illustrating a method for manufacturing the display device, according to an embodiment;
FIG. 18 is a cross-sectional view of an insulating layer illustrating a method for manufacturing the display device, according to an embodiment;
FIG. 19 is a cross-sectional view of an insulating layer illustrating a method for manufacturing the display device, according to an embodiment;
FIG. 20 is a cross-sectional view of an insulating layer illustrating a method for manufacturing the display device according to an embodiment;
FIG. 21 is a cross-sectional view of an insulating layer illustrating a method for manufacturing the display device according to an embodiment;
FIG. 22 is a cross-sectional view of an insulating layer illustrating a method for manufacturing the display device according to an embodiment;
FIG. 23 is a cross-sectional view of an insulating layer illustrating a method for manufacturing the display device according to an embodiment;
FIG. 24 is a cross-sectional view of an insulating layer illustrating a method for manufacturing the display device according to an embodiment;
FIG. 25 is a diagram illustrating a virtual reality device including a display device, according to an embodiment;
FIG. 26 is a diagram illustrating a virtual reality device including a display device, according to an embodiment; and
FIG. 27 is a diagram illustrating a virtual reality device including a display device, according to an embodiment.

### DETAILED DESCRIPTION

The present invention will now be described more fully hereinafter with reference to the accompanying drawings, in which preferred embodiments of the invention are shown. This invention may, however, be embodied in different forms and should not be construed as limited to the embodiments set forth herein. Rather, these embodiments are provided so that this disclosure will be thorough and complete, and will fully convey the scope of the invention to those skilled in the art.

It will also be understood that when an element or a layer is referred to as being "on" another element or layer, it can be directly on the other element or layer, or intervening layers may also be present. The same reference numbers indicate the same components throughout the specification.

It will be understood that, although the terms "first," "second," etc. may be used herein to describe various elements, these elements should not be limited by these terms. These terms are only used to distinguish one element from another element. For instance, a first element discussed below could be termed a second element without departing from the teachings of the present invention. Similarly, the second element could also be termed the first element. The description of an element as a "first" element may not require or imply the presence of a second element or other elements. The terms "first", "second", etc. may also be used herein to differentiate different categories or sets of elements. For conciseness, the terms "first", "second", etc. may represent "first-category (or first-set)", "second-category (or second-set)", etc., respectively.

It will also be understood that when a layer is referred to as being "connected to" or "coupled to" another element, layer or substrate, it can be directly on the other element, layer or substrate, or intervening elements, layers or substrates may also be present. Likewise, those referred to as "Below", "Left", and "Right" include cases where they are directly adjacent to other elements or cases where another layer or other material is interposed. To this end, the term "connected" may refer to physical, electrical, and/or fluid connection, with or without intervening elements.

Unless otherwise specified, the illustrated embodiments are to be understood as providing features of varying detail of some ways in which the disclosure may be implemented in practice. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the scope of the invention.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements.

Further, the X-axis, the Y-axis, and the Z-axis are not limited to three axes of a rectangular coordinate system, and thus the X-, Y-, and Z- axes, and may be interpreted in a broader sense. For example, the X-axis, the Y-axis, and the Z-axis may be perpendicular to one another, or may represent different directions that are not perpendicular to one another.

For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, ZZ, or the like. As used herein, the term "and/or" includes any and all combinations of one or more of the associated listed items.

Spatially relative terms, such as "beneath," "below," "under," "lower," "above," "upper," "over," "higher," "side" (e.g., as in "sidewall"), and the like, may be used herein for descriptive purposes, and, thereby, to describe one element's relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein should be interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments may be described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not be construed as limited to the particular illustrated shapes of regions, but are to include deviations in shapes that result from, for instance, manufacturing. In this manner, regions illustrated in the drawings may be schematic in nature, and the shapes of these regions may not reflect actual shapes of regions of a device and, as such, are not intended to be limiting.

As customary in the field, some embodiments are described and illustrated in the accompanying drawings in terms of functional blocks, units, parts, and/or modules. Those skilled in the art will appreciate that these blocks, units, parts, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, parts, and/or modules being implemented by microprocessors or other similar hardware, they may be programmed and controlled using software (e.g., microcode) to perform various functions discussed herein and may optionally be driven by firmware and/or software. It is also contemplated that each block, unit, part, and/or module may be implemented by dedicated hardware, or as a combination of dedicated hardware to perform some functions and a processor (e.g., one or more programmed microprocessors and associated circuitry) to perform other functions.

Also, each block, unit, part, and/or module of some embodiments may be physically separated into two or more interacting and discrete blocks, units, parts, and/or modules without departing from the scope of the invention. Further, the blocks, units, parts, and/or modules of some embodiments may be physically combined into more complex blocks, units, parts, and/or modules without departing from the scope of the invention.

Unless otherwise defined or implied herein, all terms (including technical and scientific terms) used herein have the same meaning as commonly understood by those skilled in the art to which this disclosure pertains. It will be further understood that terms, such as those defined in commonly used dictionaries, should be interpreted as having a meaning that is consistent with their meaning in the context of the relevant art and the disclosure, and should not be interpreted in an ideal or excessively formal sense unless clearly so defined herein.

Features of each of various embodiments of the invention may be partially or entirely combined with each other and may technically variously interwork with each other, and respective embodiments may be implemented independently of each other or may be implemented together in association with each other.

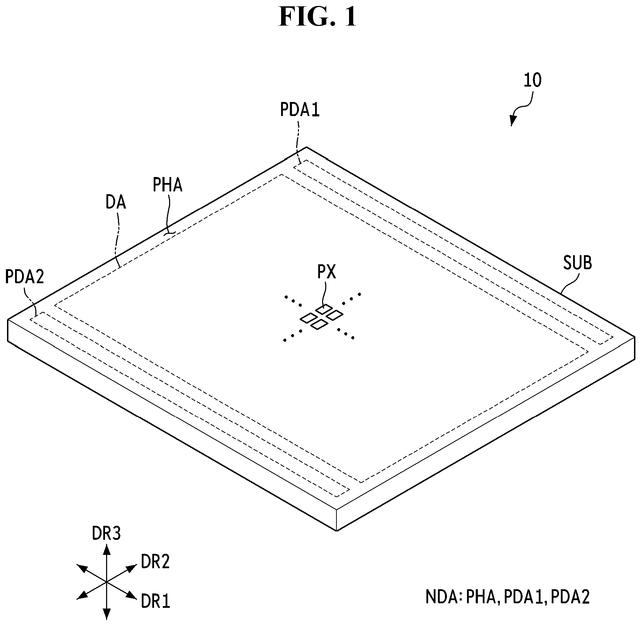

FIG. 1 is a perspective view of a display device, according to an embodiment.

In an embodiment and referring to FIG. 1, a display device 10 is a device for displaying a moving image or a still image and may be used as a display screen for various products. For example, the display device 10 may be used as a display screen for various products such as televisions, laptop computers, monitors, billboards and the Internet of Things (IOT) as well as portable electronic devices such as mobile phones, smart phones, tablet personal computers (tablet PCs), smart watches, watch phones, mobile communication terminals, electronic notebooks, electronic books, portable multimedia players (PMPs), navigation systems and ultra mobile PCs (UMPCs). Additionally, the display device 10 may be applied to a virtual reality (VR) device, an augmented reality (AR) device, or the like.

In an embodiment, the display device 10 may be a light-emitting display device including a light-emitting element. For example, the display device 10 may be a light-emitting display device such as an organic light-emitting display including an organic light-emitting diode, a quantum dot light-emitting display including a quantum dot light-emitting layer, an inorganic light-emitting display including an inorganic semiconductor, or an ultra-small light-emitting display using an ultra-small light-emitting diode such as a micro or nano light-emitting diode (micro LED or nano LED). However, the invention is not limited thereto. For example, the display device 10 may be another type of display device other than a light-emitting display device.

Hereinafter, embodiments in which the display device 10 is an organic light-emitting display device will be disclosed. However, the display device 10 is not limited to the organic light-emitting display device, and the technical features of the embodiments described later may be applied to other types of display devices.

The display device 10, according to an embodiment, may include a substrate SUB and pixels PX disposed on the substrate SUB.

In an embodiment, the substrate SUB may be a base layer for manufacturing or providing the display device 10. The substrate SUB may have a quadrilateral planar shape on a plane defined by a first direction DR1 and a second direction DR2, but is not limited thereto. For example, the substrate SUB may have a polygonal shape other than a quadrilateral shape, a circular shape, an elliptical shape, or an irregular shape in a plan view.

In FIG. 1, the first direction DR1 may refer to a horizontal direction (or vertical direction) of the substrate SUB (or display device 10), and the second direction DR2 may refer to a vertical direction (or horizontal direction) of the substrate SUB. A third direction DR3 may refer to a thickness direction or a height direction of the substrate SUB.

In an embodiment, the substrate SUB and the display device 10 including the same may include a display area DA and a non-display area NDA, where the display area DA may be an area in which an image is displayed, and the non-display area NDA may be an area other than the display area DA.

The display area DA may be an area where the pixels PX are disposed. For example, the pixels PX and wires (or some of the wires) connected to the pixels PX may be disposed in the display area DA. In describing embodiments, the term "connect" may include electrical connection and/or physical connection.

The non-display area NDA may be disposed around the display area DA. In an embodiment, the non-display area NDA may include a first pad area PDA1, a second pad area PDA2, and a peripheral area PHA. In an embodiment, the non-display area NDA may further include a common voltage supply area, or the like wires connected to the pixels PX (e.g., some of the wires extending from the display area DA to the non-display area NDA) and pads may be disposed in the non-display area NDA.

Although FIG. 1 illustrates an embodiment in which the display device 10 includes the first pad area PDA1 and the second pad area PDA2 disposed on different sides (e.g., an upper side and a lower side, respectively) of the display area DA, the number or position of the pad areas PDA1 and PDA2 is not limited. As an example, in another embodiment, the display device 10 may include only one of the first pad area PDA1 and the second pad area PDA2.

In an embodiment, each of the first pad area PDA1 and the second pad area PDA2 may include pads connected to an external circuit board. Driving signals and power voltages for driving the pixels PX may be supplied from the circuit board to the display device 10 through the pads.

In an embodiment, the peripheral area PHA may be the remaining area of the non-display area NDA excluding the first pad area PDA1 and the second pad area PDA2. The peripheral area PHA may surround the display area DA.

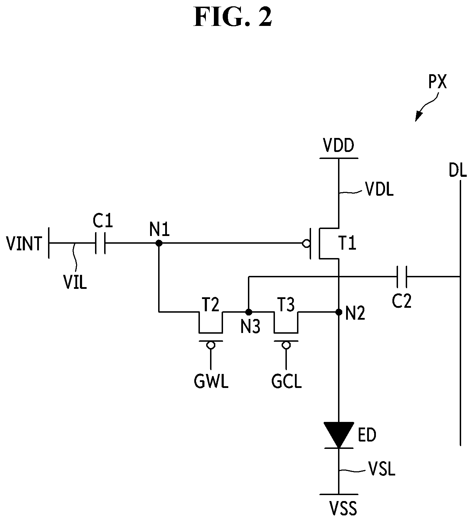

FIG. 2 is an equivalent circuit diagram illustrating a pixel, according to an embodiment.

In an embodiment and referring to FIG. 2, the pixel PX may be connected to signal lines including a first scan line GWL, a second scan line GCL, and a data line DL, and power lines including a first voltage line VDL, a second voltage line VSL, and an initialization voltage line VIL (or an initialization signal line). The type or number or the like of signal lines and power lines connected to the pixel PX may vary depending on the type or structure of the pixel PX.

In an embodiment, the first scan line GWL and the second scan line GCL may be connected between a scan driving circuit and the pixel PX, where the first scan line GWL transmits the first scan signal outputted from the scan driving circuit to the pixel PX. In an embodiment, the first scan line GWL may be a write scan line, and the first scan signal may be a write scan signal. The second scan line GCL transmits the second scan signal outputted from the scan driving circuit to the pixel PX. In an embodiment, the second scan line GCL may be a control scan line, and the second scan signal may be a control scan signal. The scan driving circuit may be disposed on a circuit board connected to the display device 10 through signal pads (e.g., scan pads) disposed on the substrate SUB or disposed in at least one of the first pad area PDA1 or the second pad area PDA2.

In an embodiment, the data line DL may be connected between the data driving circuit and the pixel PX. The data line DL transmits the data voltage outputted from the data driving circuit to the pixel PX, where the data driving circuit may be disposed on a circuit board connected to the display device 10 through signal pads (e.g., data pads) disposed on the substrate SUB or disposed in at least one of the first pad area PDA1 or the second pad area PDA2.

In an embodiment, the first voltage line VDL and the second voltage line VSL may be connected between a power supply circuit and the pixel PX. The first voltage line VDL and the second voltage line VSL transmit the first power voltage VDD and the second power voltage VSS outputted from the power supply circuit to the pixel PX. In an embodiment, the first power voltage VDD may be a high-potential pixel voltage, and the second power voltage VSS may be a low-potential pixel voltage. The power supply circuit may be disposed on the circuit board connected to the display device 10 through the power pads disposed in at least one of the first pad area PDA1 or the second pad area PDA2.

In an embodiment, the initialization voltage line VIL may be connected between the power supply circuit or the scan driving circuit and the pixel PX. The initialization voltage line VIL transmits the initialization voltage VINT outputted from the power supply circuit or the scan driving circuit to the pixel PX.

In an embodiment, the pixel PX may include a light-emitting element ED and a pixel circuit electrically connected to the light-emitting element ED.

The light-emitting element ED may be connected between the pixel circuit and the second voltage line VSL. For example, the first electrode (e.g., anode electrode) of the light-emitting element ED may be connected to the pixel circuit through a second node N2, and the second electrode (e.g., cathode electrode) of the light-emitting element ED may be connected to the second voltage line VSL.

In an embodiment, the light-emitting element ED may be a light source of the pixel PX and may emit light corresponding to the driving current supplied from the pixel circuit. In an embodiment, the light-emitting element ED may be an organic light-emitting diode, but is not limited thereto. For example, in another embodiment, the light-emitting element ED may be an inorganic light-emitting element, a quantum dot light-emitting element, or another type of light-emitting element.

In an embodiment, the pixel circuit may be connected between the first voltage line VDL and the light-emitting element ED. Additionally, the pixel circuit may be further connected to the first scan line GWL, the second scan line GCL, the data line DL, and the initialization voltage line VIL.

In an embodiment, the pixel circuit may include first, second, and third transistors T1, T2, and T3, respectively, and first and second capacitors C1 and C2, respectively. In addition to the embodiment of FIG. 2, the type or structure of the pixel circuit may be changed in various ways. In an embodiment, the transistors T1, T2, and T3 may be P-type transistors, but they are not limited thereto. For example, in another embodiment, at least one of the transistors T1, T2, and T3 may be changed to an N-type transistor. Each of the transistors T1, T2, and T3 may include a gate electrode, a source electrode, and a drain electrode. The source electrode and the drain electrode of each of the transistors T1, T2, and T3 may be a first electrode and a second electrode other than the gate electrode of each of the transistors T1, T2, and T3, and may be determined according to the voltage applied to both ends of each of the transistors T1, T2, and T3 or the type (e.g., P-type or N-type transistor) of each of the transistors T1, T2, and T3.

The gate electrode of the first transistor T1 may be connected to a first node N1, the source electrode thereof may be connected to the first voltage line VDL, and the drain electrode thereof may be connected to the second node N2. The second node N2 may be a node to which the first electrode (e.g., anode electrode) of the light-emitting element ED is connected. The first transistor T1 may control the driving current flowing through the light-emitting element ED according to the voltage of the first node N1.

The gate electrode of the second transistor T2 may be connected to the first scan line GWL, the source electrode thereof may be connected to the first node N1, and the drain electrode thereof may be connected to a third node N3. The second transistor T2 may be turned on by the first scan signal of the gate-on voltage applied to the first scan line GWL to electrically connect the first node N1 to the third node N3.

The first node N1 may be connected to the first electrode of the first capacitor C1, and the voltage of the first node N1 may be initialized by the initialization voltage VINT applied to the initialization voltage line VIL connected to the second electrode of the first capacitor C1. The third node N3 may be connected to the first electrode of the second capacitor C2, and the voltage of the third node N3 may be changed to a voltage corresponding to the data voltage applied to the data line DL connected to the second electrode of the second capacitor C2.

The gate electrode of the third transistor T3 may be connected to the second scan line GCL, the source electrode thereof may be connected to the third node N3, and the drain electrode thereof may be connected to the second node N2. The third transistor T3 may be turned on by the second scan signal of the gate-on voltage applied to the second scan line GCL to electrically connect the third node N3 to the second node N2.

The first capacitor C1 may be connected between the first node N1 and the initialization voltage line VIL. For example, the first electrode of the first capacitor C1 may be connected to the first node N1, and the second electrode of the first capacitor C1 may be connected to the initialization voltage line VIL, so that the potential difference between the first node N1 and the initialization voltage line VIL may be maintained. The voltage of the first node N1 may be initialized by the initialization voltage VINT applied to the initialization voltage line VIL.

The second capacitor C2 may be connected between the third node N3 and the data line DL. For example, the first electrode of the second capacitor C2 may be connected to the third node N3, and the second electrode of the second capacitor C2 may be connected to the data line DL, so that the potential difference between the third node N3 and the data line DL may be maintained. The voltage of the third node N3 may be changed to a voltage corresponding to the data voltage applied to the data line DL.

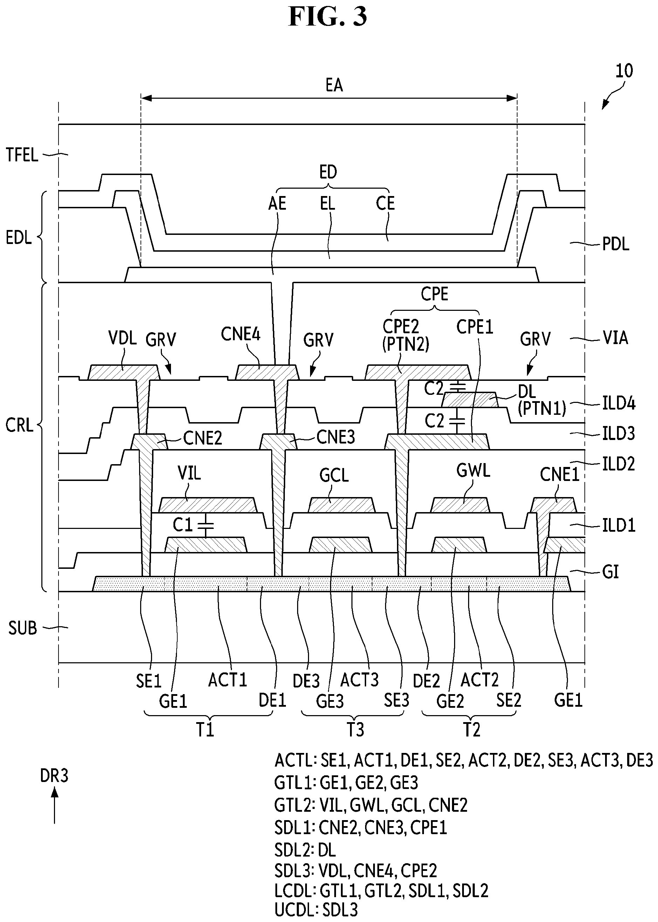

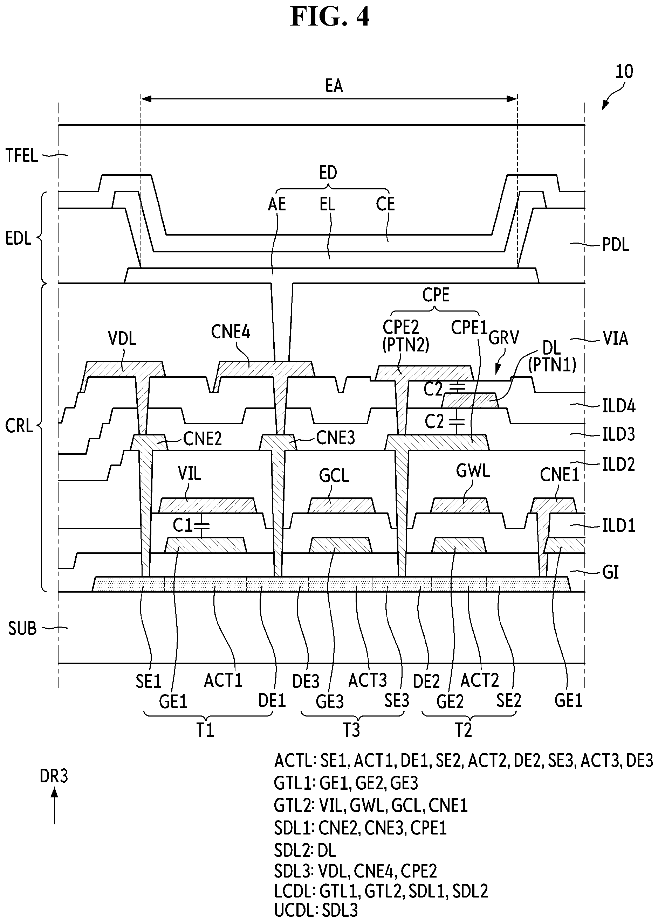

FIG. 3 is a cross-sectional view illustrating a display device, according to an embodiment. FIG. 4 is a cross-sectional view illustrating a display device, according to an embodiment.

Each of FIGS. 3 and 4 illustrates a schematic cross section of a portion (e.g., one pixel area positioned in the display area DA) of the display device 10, in which the pixel PX is disposed, according to an embodiment. FIGS. 3 and 4 illustrate different embodiments with respect to the pattern shape of a fourth interlayer insulating layer ILD4 and a third source-drain conductive layer SDL3.

In an embodiment and referring to FIGS. 3 and 4, the display device 10 may include the substrate SUB and a circuit layer CRL disposed on the substrate SUB. In an embodiment, the display device 10 may be a light-emitting display device including the light-emitting element ED, and may further include a light-emitting element layer EDL and an encapsulation layer TFEL. In an embodiment, the circuit layer CRL, the light-emitting element layer EDL, and the encapsulation layer TFEL may be sequentially disposed on the substrate SUB along the third direction DR3.

In an embodiment, the substrate SUB may be a base layer for forming the display device 10. For example, the substrate SUB may form a support for a display panel including the pixels PX.

In an embodiment, the substrate SUB may be a substrate that includes an insulating material such as glass and has rigid characteristics, but is not limited thereto. For example, in another embodiment, the substrate SUB may include an insulating material such as polymer resin and may be a flexible substrate capable of transformation such as bending, folding, or rolling. In still another embodiment, the substrate SUB may be a semiconductor substrate, and the substrate SUB and the pixel circuit may be formed of a semiconductor circuit substrate including a complementary metal-oxide semiconductor (CMOS) circuit formed using a semiconductor process.

In an embodiment, the circuit layer CRL may include circuit elements included in each of the pixels PX (e.g., circuit elements included in each pixel circuit) and wires connected to the pixels PX. For example, the circuit layer CRL may include the transistors T1, T2, and T3, the capacitors C1 and C2, the first scan line GWL, the second scan line GCL, the data line DL, the first voltage line VDL, the second voltage line VSL, and the initialization voltage line VIL of FIG. 2.

The circuit layer CRL may include at least one semiconductor layer, a plurality of conductive layers, and a plurality of insulating layers disposed on the substrate SUB. In an embodiment, the semiconductor layer of the circuit layer CRL may include an active layer ACTL including channel regions ACT1, ACT2, and ACT3 of the transistors T1, T2, and T3, respectively. In an embodiment, the conductive layers of the circuit layer CRL may include a first gate conductive layer GTL1, a second gate conductive layer GTL2, a first source-drain conductive layer SDL1 (also referred to as "first data conductive layer"), a second source-drain conductive layer SDL2 (also referred to as "second data conductive layer"), and the third source-drain conductive layer SDL3 (also referred to as "third data conductive layer"). In an embodiment, the insulating layers of the circuit layer CRL may include a gate insulating layer GI, a first interlayer insulating layer ILD1, a second interlayer insulating layer ILD2, a third interlayer insulating layer ILD3, the fourth interlayer insulating layer ILD4, and an upper insulating layer VIA (also referred to as "via layer" or "planarization organic layer"). In an embodiment, the active layer ACTL, the gate insulating layer GI, the first gate conductive layer GTL1, the first interlayer insulating layer ILD1, the second gate conductive layer GTL2, the second interlayer insulating layer ILD2, the first source-drain conductive layer SDL1, the third interlayer insulating layer ILD3, the second source-drain conductive layer SDL2, the fourth interlayer insulating layer ILD4, the third source-drain conductive layer SDL3, and the upper insulating layer VIA of the circuit layer CRL may be sequentially disposed on the substrate SUB along the third direction DR3.

The structure of the circuit layer CRL is not limited to the embodiment of FIG. 3. For example, in another embodiment, the number or position of semiconductor layers, conductive layers, insulating layers included in the circuit layer CRL, and the types, shapes, or the like of patterns included in the semiconductor layer, the conductive layers, and insulating layers may be changed in various ways depending on the design structure of the pixel circuits and the wires.

In an embodiment, the active layer ACTL may be disposed on the substrate SUB. The active layer ACTL may include a semiconductor material (e.g., polysilicon, amorphous silicon, oxide semiconductor, or other semiconductor materials). The active layer ACTL may include the channel regions ACT1, ACT2, and ACT3, source electrodes SE1, SE2, and SE3 (or source regions), and drain electrodes DE1, DE2, and DE3 (or drain regions) of the transistors T1, T2, and T3, respectively. For example, the active layer ACTL may include the first channel region ACT1, the first source electrode SE1, and the first drain electrode DE1 that constitute the first transistor T1, the second channel region ACT2, the second source electrode SE2, and the second drain electrode DE2 that constitute the second transistor T2, and the third channel region ACT3, the third source electrode SE3, and the third drain electrode DE3 that constitute the third transistor T3.

In an embodiment, the gate insulating layer GI may be disposed on the active layer ACTL. For example, the gate insulating layer GI may be disposed on the substrate SUB to cover the active layer ACTL. The gate insulating layer GI may be disposed between the active layer ACTL and the first gate conductive layer GTL1.

In an embodiment, the first gate conductive layer GTL1 may be disposed on the gate insulating layer GI, where the first gate conductive layer GTL1 may include the gate electrodes GE1, GE2, and GE3 of the transistors T1, T2, and T3, respectively. For example, the first gate conductive layer GTL1 may include the first gate electrode GE1 constituting the first transistor T1, the second gate electrode GE2 constituting the second transistor T2, and the third gate electrode GE3 constituting the third transistor T3. The first gate electrode GE1, the second gate electrode GE2, and the third gate electrode GE3 may overlap the first channel region ACT1, the second channel region ACT2, and the third channel region ACT3, respectively. The first gate electrode GE1 illustrated by being separated into two patterns in FIG. 3 may be the first gate electrode GE1 that is single and connected when viewed in a plan view.

In an embodiment, the first interlayer insulating layer ILD1 may be disposed on the first gate conductive layer GTL1. For example, the first interlayer insulating layer ILD1 may be disposed on the gate insulating layer GI to cover the first gate conductive layer GTL1. The first interlayer insulating layer ILD1 may be disposed between the first gate conductive layer GTL1 and the second gate conductive layer GTL2.

In an embodiment, the second gate conductive layer GTL2 may be disposed on the first interlayer insulating layer ILD1, where the second gate conductive layer GTL2 may include the initialization voltage line VIL, the first scan line GWL, the second scan line GCL, and the first connection electrode CNE1. The initialization voltage line VIL may overlap the first gate electrode GE1. For example, a part of the initialization voltage line VIL and a part of the first gate electrode GE1 may overlap each other in the third direction DR3. The first capacitor C1 may be formed in a portion in which the initialization voltage line VIL and the first gate electrode GE1 overlap. In a portion not illustrated in FIG. 3, the first scan line GWL may be connected to the second gate electrode GE2, and the second scan line GCL may be connected to the third gate electrode GE3. The first connection electrode CNE1 may connect the first gate electrode GE1 to the second source electrode SE2. In another embodiment, the display device 10 may not include the first connection electrode CNE1, and the first gate electrode GE1 may be directly connected to the second source electrode SE2.

In an embodiment, the second interlayer insulating layer ILD2 may be disposed on the second gate conductive layer GTL2. For example, the second interlayer insulating layer ILD2 may be disposed on the first interlayer insulating layer ILD1 to cover the second gate conductive layer GTL2. The second interlayer insulating layer ILD2 may be disposed between the second gate conductive layer GTL2 and the first source-drain conductive layer SDL1.

In an embodiment, the first source-drain conductive layer SDL1 may be disposed on the second interlayer insulating layer ILD2, where the first source-drain conductive layer SDL1 may include a second connection electrode CNE2, a third connection electrode CNE3, and a first capacitor electrode CPE1. The second connection electrode CNE2 may connect the first source electrode SE1 to the first voltage line VDL. In another embodiment, the display device 10 may not include the second connection electrode CNE2, and the first source electrode SE1 may be directly connected to the first voltage line VDL. The third connection electrode CNE3 may connect the first drain electrode DE1 and the third drain electrode DE3 to a fourth connection electrode CNE4. In another embodiment, the display device 10 may not include the third connection electrode CNE3, and the first drain electrode DE1 and the third drain electrode DE3 may be directly connected to the fourth connection electrode CNE4. The first capacitor electrode CPE1 may be connected to the second drain electrode DE2 and the third source electrode SE3. The first capacitor electrode CPE1 may overlap the data line DL. For example, a part of the first capacitor electrode CPE1 and a part of the data line DL may overlap each other in the third direction DR3. The second capacitor C2 may be formed in a portion in which the first capacitor electrode CPE1 and the data line DL overlap.

In an embodiment, the first capacitor electrode CPE1 may be connected to a second capacitor electrode CPE2, and the first capacitor electrode CPE1 and the second capacitor electrode CPE2 may constitute one capacitor electrode CPE. For example, the first electrode of the second capacitor C2 may be the capacitor electrode CPE including the first capacitor electrode CPE1 and the second capacitor electrode CPE2. In another embodiment, the display device 10 may not include the first capacitor electrode CPE1 or the second capacitor electrode CPE2, and the first electrode of the second capacitor C2 may be the capacitor electrode CPE constituted with the first capacitor electrode CPE1 or the second capacitor electrode CPE2. In an embodiment, when the display device 10 does not include all of the second connection electrode CNE2, the third connection electrode CNE3, and the first capacitor electrode CPE1, the display device 10 may not include the first source-drain conductive layer SDL1 and the third interlayer insulating layer ILD3.

In an embodiment, the third interlayer insulating layer ILD3 may be disposed on the first source-drain conductive layer SDL1. For example, the third interlayer insulating layer ILD3 may be disposed on the second interlayer insulating layer ILD2 to cover the first source-drain conductive layer SDL1. The third interlayer insulating layer ILD3 may be disposed between the first source-drain conductive layer SDL1 and the second source-drain conductive layer SDL2.

In an embodiment, the second source-drain conductive layer SDL2 may be disposed on the third interlayer insulating layer ILD3, where the second source-drain conductive layer SDL2 may include the data line DL. The data line DL may overlap the first capacitor electrode CPE1 and the second capacitor electrode CPE2. The second capacitor C2 may be formed in a portion in which the data line DL overlaps the first capacitor electrode CPE1 and the second capacitor electrode CPE2.

In an embodiment, the fourth interlayer insulating layer ILD4 may be disposed on the second source-drain conductive layer SDL2. For example, the fourth interlayer insulating layer ILD4 may be disposed on the third interlayer insulating layer ILD3 to cover the second source-drain conductive layer SDL2. The fourth interlayer insulating layer ILD4 may be disposed between the second source-drain conductive layer SDL2 and the third source-drain conductive layer SDL3.

In an embodiment, the third source-drain conductive layer SDL3 may be disposed on the fourth interlayer insulating layer ILD4, where the third source-drain conductive layer SDL3 may include the first voltage line VDL, the fourth connection electrode CNE4, and the second capacitor electrode CPE2. The first voltage line VDL may be connected to the second connection electrode CNE2, and the fourth connection electrode CNE4 may connect the third connection electrode CNE3 (or the first drain electrode DE1 and the third drain electrode DE3) to a first electrode AE of the light-emitting element ED. The second capacitor electrode CPE2 may be connected to the first capacitor electrode CPE1 (or the second drain electrode DE2 and the third source electrode SE3).

In an embodiment, the patterns included in each of the conductive layers of the circuit layer CRL may be single-layer or multilayer patterns including at least one conductive material. For example, each of the electrodes, the conductive patterns, and/or the wires included in the first gate conductive layer GTL1, the second gate conductive layer GTL2, the first source-drain conductive layer SDL1, the second source-drain conductive layer SDL2, and the third source-drain conductive layer SDL3 may include at least one of molybdenum (Mo), aluminum (Al), chromium (Cr), gold (Au), silver (Ag), titanium (Ti), nickel (Ni), neodymium (Nd), copper (Cu), or other metals, alloys thereof, or other conductive materials, and may have a single-layer or multilayer structure. At least two conductive layers of the first gate conductive layer GTL1, the second gate conductive layer GTL2, the first source-drain conductive layer SDL1, the second source-drain conductive layer SDL2, and the third source-drain conductive layer SDL3 may include the same material or may include different materials. In an embodiment, patterns included in the same conductive layer may include the same conductive material and may have substantially the same cross-sectional structure.

In an embodiment, the upper insulating layer VIA may be disposed on the third source-drain conductive layer SDL3. For example, the upper insulating layer VIA may be disposed on the fourth interlayer insulating layer ILD4 to cover the third source-drain conductive layer SDL3. The upper insulating layer VIA may be disposed between the third source-drain conductive layer SDL3 and the first electrode AE of the light-emitting element ED.

In an embodiment, each of the insulating layers of the circuit layer CRL may include at least one insulating material and may have a single-layer or multilayer structure. For example, each of the gate insulating layer GI, the first interlayer insulating layer ILD1, the second interlayer insulating layer ILD2, the third interlayer insulating layer ILD3, the fourth interlayer insulating layer ILD4, and the upper insulating layer VIA may include an organic insulating material and/or an inorganic insulating material and may have a single-layer or multilayer structure. At least two insulating layers of the insulating layers of the circuit layer CRL may include the same material or may include different materials.

In an embodiment, each of the gate insulating layer GI, the first interlayer insulating layer ILD1, the second interlayer insulating layer ILD2, the third interlayer insulating layer ILD3, and the fourth interlayer insulating layer ILD4 may be a single-layer or multilayer inorganic insulating layer including an inorganic insulating material (e.g., silicon nitride, silicon oxide, silicon oxynitride, titanium oxide, aluminum oxide, or other inorganic insulating materials). Accordingly, the thickness of the circuit layer CRL may be reduced or minimized.

In an embodiment, the upper insulating layer VIA may include an organic insulating material (e.g., acryl resin, epoxy resin, phenolic resin, polyamide resin, polyimide resin, or other organic insulating materials). The top surface of the upper insulating layer VIA may be substantially flat. Accordingly, the top surface of the circuit layer CRL may be substantially flat.

In an embodiment, the inorganic insulating layers of the circuit layer CRL may have stepped portions depending on patterns disposed therein below. For example, each of the inorganic insulating layers may have an overall uniform thickness and may protrude in the third direction DR3 at a portion in which at least one pattern is disposed therein below. As an example, the gate insulating layer GI may protrude in the third direction DR3 from a portion in which the active layer ACTL is disposed.

In the embodiment of at least one inorganic insulating layer positioned in the upper layer portion of the circuit layer CRL among the inorganic insulating layers, a relatively large number of conductive layers and/or semiconductor layers are disposed therein below, so that stepped portions due to the lower patterns may be relatively large compared to other inorganic insulating layers positioned in the lower layer portion of the circuit layer CRL. Additionally, in the case of the high-resolution display device 10, the density of the patterns is high, so that larger stepped portions may occur in the inorganic insulating layers.

When the stepped portion of the inorganic insulating layer is large, the risk of defects occurring in the patterns of the conductive layer disposed on the inorganic insulating layer may increase. For example, a pattern disposed on a portion of the inorganic insulating layer with a large, stepped portion may be disconnected.

However, in the embodiment of FIG. 3, the inorganic insulating layer, in which a relatively large, stepped portion may occur due to the lower patterns among the inorganic insulating layers, may be planarized, so that the stepped portion of the inorganic insulating layer may be alleviated or removed. For example, the inorganic insulating layer may be etched to the extent that a groove GRV is formed in the inorganic insulating layer at a portion in which the inorganic insulating layer may protrude to its highest height. Accordingly, the stepped portion of the inorganic insulating layer may be alleviated or removed, so that the inorganic insulating layer may be further planarized.

In an embodiment, in a portion of the fourth interlayer insulating layer ILD4 including a portion in which the fourth interlayer insulating layer ILD4 may protrude to the highest height level due to the patterns of the semiconductor layer and the conductive layers disposed therein below, the stepped portion of the fourth interlayer insulating layer ILD4 may be alleviated or removed by etching the fourth interlayer insulating layer ILD4 to a certain thickness. For example, when the data line DL is disposed at the highest position among the patterns of the second source-drain conductive layer SDL2, a portion of the fourth interlayer insulating layer ILD4 including a portion covering the data line DL may be etched. Accordingly, the thickness of the fourth interlayer insulating layer ILD4 may be reduced in a portion corresponding to the highest height level of the second source-drain conductive layer SDL2 disposed immediately below the fourth interlayer insulating layer ILD4. As an example, the fourth interlayer insulating layer ILD4 may have a minimum thickness at a portion corresponding to the highest height of the second source-drain conductive layer SDL2 disposed immediately below the fourth interlayer insulating layer ILD4 and may have a thickness greater than or equal to the minimum thickness in other portions.

In an embodiment, in order to stably or effectively alleviate the stepped portion of the fourth interlayer insulating layer ILD4, a portion in which the fourth interlayer insulating layer ILD4 is etched is over-etched by a thickness including a process margin (e.g., approximately 500 Å), so that the groove GRV with a depth corresponding to the process margin may be formed in the fourth interlayer insulating layer ILD4. For example, by over-etching the portion in which the fourth interlayer insulating layer ILD4 is etched to a thickness including the process margin of about 500 Å, the groove GRV having a depth of about 500 Å or a depth in a range including about 500 Å, for example, a depth in a range of about 200 Å to about 800 Å may be formed in the fourth interlayer insulating layer ILD4. For example, when carrying out an etching process aiming to form a groove (GRV) with a depth of about 500 Å, the depth of the groove (GRV) may be approximately between about 200 Å and about 800 Å depending on the process conditions, even if the groove (GRV) is not formed to the exact depth.

Accordingly, the flatness of a second pattern PTN2 disposed on the groove GRV, for example, the second capacitor electrode CPE2, may be increased, and disconnection of the second capacitor electrode CPE2 may be stably prevented. In addition, by alleviating the stepped portion of the fourth interlayer insulating layer ILD4 by the etching method rather than using the chemical mechanical polishing (CMP) method, the stepped portion of the fourth interlayer insulating layer ILD4 may be appropriately alleviated or removed without the risk of short circuit defects due to foreign matters, excessive polishing, or the like that may occur in the polishing process by the CMP method.

In an embodiment, as illustrated in FIG. 3, the fourth interlayer insulating layer ILD4 may be etched in the thickness direction to have the groove GRV at each of a portion covering a first pattern PTN1 (e.g., the data line DL in FIGS. 3 and 4) that protrudes to the highest height among the patterns of the second source-drain conductive layer SDL2 disposed immediately below the fourth interlayer insulating layer ILD4, and a portion (e.g., in FIGS. 3 and 4, a portion covering the second connection electrode CNE2, the third connection electrode CNE3, and the first capacitor electrode CPE1) covering a portion in which the third interlayer insulating layer ILD3 disposed immediately below the second source-drain conductive layer SDL2 protrudes to the highest height level. For example, the fourth interlayer insulating layer ILD4 may have the groove GRV by being etched at portions including a portion (hereinafter referred to as "primary stepped portion") in which the fourth interlayer insulating layer ILD4 protrudes the highest due to the lower patterns such that the fourth interlayer insulating layer ILD4 may have the highest stepped portion, and a portion (hereinafter referred to as "secondary stepped portion") that protrudes to a height next to the height of the primary stepped portion due to the lower patterns such that the fourth interlayer insulating layer ILD4 may have the second highest stepped portion.

In an embodiment, as the fourth interlayer insulating layer ILD4 is partially etched, the fourth interlayer insulating layer ILD4 may have a relatively reduced thickness in the portion in which the groove GRV is formed compared to the remaining portions. Other portions of the fourth interlayer insulating layer ILD4 other than the portion including the groove GRV may not be etched, and thus, the other portions of the fourth interlayer insulating layer ILD4 may have stepped portions corresponding to patterns (hereinafter also referred to as "lower patterns") of a lower conductive layer LCDL.

In another embodiment, as illustrated in FIG. 4, the fourth interlayer insulating layer ILD4 may also have the groove GRV by being etched in the thickness direction only in a portion covering a portion that protrudes to the highest height level among the patterns of the second source-drain conductive layer SDL2. For example, the fourth interlayer insulating layer ILD4 may have the groove GRV by being etched in the thickness direction in a portion covering the first pattern PTN1 (e.g., the data line DL of FIGS. 3 and 4) that protrudes to the highest height level among the patterns of the second source-drain conductive layer SDL2, and may have stepped portions corresponding to the lower patterns without being etched in other portions.

In describing embodiments, the "first pattern PTN1" refers to a pattern disposed under an inorganic insulating layer to be planarized to alleviate or remove a stepped portion and may be a pattern disposed at the highest height level in a semiconductor layer or a conductive layer disposed under the inorganic insulating layer. For example, in the embodiments of FIGS. 3 and 4, the data line DL may be the first pattern PTN1, but another pattern other than the data line DL may be the first pattern PTN1 depending on the cross-sectional structure of the circuit layer CRL or the inorganic insulating layer to be planarized.

In addition, in describing embodiments, at least one conductive layer disposed under the first insulating layer (e.g., the fourth interlayer insulating layer ILD4) on which the planarization process is to be performed may also be referred to as a "lower conductive layer LCDL," where the lower conductive layer LCDL may include at least the first pattern PTN1.

In an embodiment, the lower conductive layer LCDL may include a plurality of conductive layers including at least one electrode among the electrodes included in circuit elements disposed in each of the pixels PX, and at least one wire among the wires connected to the circuit elements. For example, the lower conductive layer LCDL may include a plurality of conductive layers including at least one electrode among the electrodes constituting a transistor and a capacitor of each of the pixels PX, and at least one wire of the wires connected to the transistor and the capacitor. In the embodiments of FIGS. 3 and 4, the lower conductive layer LCDL may include the first gate conductive layer GTL1, the second gate conductive layer GTL2, the first source-drain conductive layer SDL1, and the second source-drain conductive layer SDL2.

Additionally, in describing embodiments, an insulating layer on which the planarization process is to be performed, for example, an inorganic insulating layer covering the first pattern PTN1, may also be referred to as "first insulating layer." For example, in the embodiments of FIGS. 3 and 4, the fourth interlayer insulating layer ILD4 may be the first insulating layer, but when it is desired to etch and planarize other insulating layers other than the fourth interlayer insulating layer ILD4 depending on the cross-sectional structure of the circuit layer CRL, the other insulating layer may be referred to as the first insulating layer.

Additionally, in describing embodiments, the "second pattern PTN2" refers to a pattern disposed on an etched portion of an inorganic insulating layer to be planarized, for example, the groove GRV, and may be a pattern formed to be substantially or relatively flat as the stepped portion of the inorganic insulating layer is alleviated. For example, in the embodiments of FIGS. 3 and 4, the second capacitor electrode CPE2 may be the second pattern PTN2, but another pattern other than the second capacitor electrode CPE2 may be the second pattern PTN2 depending on the cross-sectional structure of the circuit layer CRL or the inorganic insulating layer to be planarized.

In addition, in describing embodiments, at least one conductive layer disposed above the first insulating layer (e.g., the fourth interlayer insulating layer ILD4) on which the planarization process is to be performed may also be referred to as "upper conductive layer UCDL." For example, in the embodiments of FIGS. 3 and 4, the upper conductive layer UCDL may include the third source-drain conductive layer SDL3. In one embodiment, the upper conductive layer UCDL may be a conductive layer disposed at the uppermost portion among the conductive layers included in the circuit layer CRL. For example, in the embodiments of FIGS. 3 and 4, the upper conductive layer UCDL may be the third source-drain conductive layer SDL3. The upper conductive layer UCDL may include at least the second pattern PTN2.

Additionally, in describing embodiments, the insulating layer covering the upper conductive layer UCDL including the second pattern PTN2 may also be referred to as "second insulating layer." For example, in the embodiments of FIGS. 3 and 4, the upper insulating layer VIA may be the second insulating layer, but another insulating layer other than the upper insulating layer VIA may also be referred to as the second insulating layer depending on the cross-sectional structure of the circuit layer CRL or the inorganic insulating layer to be planarized.

For example, FIGS. 3 and 4 disclose an embodiment in which defects in patterns included in the third source-drain conductive layer SDL3 are prevented by planarizing the fourth interlayer insulating layer ILD4, but the invention is not limited thereto. For example, in an embodiment, by alleviating or removing the stepped portion of at least one insulating layer of the gate insulating layer GI, the first interlayer insulating layer ILD1, the second interlayer insulating layer ILD2, or the third interlayer insulating layer ILD3, defects of patterns included in at least one conductive layer of the first gate conductive layer GTL1, the second gate conductive layer GTL2, the first source-drain conductive layer SDL1, or the second source-drain conductive layer SDL2 may also be prevented.

In an embodiment, the light-emitting element layer EDL may be disposed on the circuit layer CRL and may be positioned in the display area DA. For example, the light-emitting element layer EDL may be disposed on the circuit layer CRL in the display area DA.

The light-emitting element layer EDL may include a pixel defining film PDL that partitions an emission area EA of each of the pixels PX, and the light-emitting element ED disposed in the emission area EA of each of the pixels PX. In an embodiment, the light-emitting element layer EDL may further include a spacer disposed on a part of the pixel defining film PDL.

In an embodiment, the light-emitting element ED may include the first electrode AE (e.g., an anode electrode) and a second electrode CE (e.g., a cathode electrode) that face each other, and a light-emitting layer EL disposed between the first electrode AE and the second electrode CE. In an embodiment, the first electrode AE, the light-emitting layer EL, and the second electrode CE may be sequentially stacked on the circuit layer CRL along the third direction DR3.

In an embodiment, the light-emitting element ED may further include at least one intermediate layer. As an example, the light-emitting element ED may further include a first intermediate layer (e.g., hole layer including a hole transport layer) interposed between the first electrode AE and the light-emitting layer EL, and a second intermediate layer (e.g., an electron layer including an electron transport layer) interposed between the light-emitting layer EL and the second electrode CE. In an embodiment, at least one intermediate layer may be a common film formed across the entire display area DA.

Although FIG. 3 discloses an embodiment in which the light-emitting element ED includes the single light-emitting layer EL, the invention is not limited thereto. For example, the light-emitting element ED may be formed in a structure of two or more tandems including at least two light-emitting layers (e.g., the light-emitting layer EL in FIG. 3 and an additional light-emitting layer overlapping the light-emitting layer EL) that overlap each other in each of the emission areas EA. Additionally, the light-emitting element ED may optionally further include a charge generation layer interposed between the at least two light-emitting layers.

In addition, although FIG. 3 discloses an embodiment in which the light-emitting layer EL is individually disposed in each of the emission areas EA, the invention is not limited thereto. For example, the light-emitting layer EL may be formed in the form of a common film formed across the entire display area DA. In this case, the color or wavelength of light emitted from the pixels PX may be controlled by a color filter layer including color filters corresponding to the color of light desired to be emitted from each of the pixels PX and/or a light conversion layer (e.g., a light conversion layer including wavelength conversion particles such as quantum dots) on the light-emitting elements ED of the pixels PX.

In an embodiment, the first electrode AE of the light-emitting element ED may be disposed on the circuit layer CRL. For example, the first electrode AE may be disposed on the upper insulating layer VIA to correspond to each emission area EA, where the first electrode AE may be connected to the fourth connection electrode CNE4 through a via hole penetrating the upper insulating layer VIA. The first electrode AE may include at least one conductive material and may be formed as a single layer or multiple layers. In an embodiment, the first electrode AE may include a reflective electrode layer including a metal material with high reflectivity.

In an embodiment, the light-emitting layer EL of the light-emitting element ED may include a high molecular material or a low molecular material, where light emitted from the light-emitting layer EL may contribute to image display. In an embodiment, the light-emitting layer EL may be provided for each pixel PX, and the light-emitting layer EL of each pixel PX may emit visible light of a color or wavelength corresponding to the corresponding pixel PX. In another embodiment, the light-emitting layer EL may be a common layer shared by the pixels PX of different colors, and a light conversion layer and/or color filters corresponding to the color (or wavelength) of light desired to be emitted from each pixel PX may be disposed in the emission areas EA of at least some of the pixels PX.

In an embodiment, the second electrode CE of the light-emitting element ED may include a conductive material. In an embodiment, the second electrode CE may be a common film formed across the entire display area DA to cover the light-emitting layer EL and the pixel defining film PDL. In an embodiment, the second electrode CE may include transparent conductive oxide (TCO) such as ITO or IZO capable of transmitting light or a semi-transmissive conductive material such as magnesium (Mg), silver (Ag), or an alloy of magnesium (Mg) and silver (Ag).

In an embodiment, the pixel defining film PDL may have an opening corresponding to each of the emission areas EA and may surround the emission areas EA. For example, the pixel defining film PDL may be formed to cover an edge of the first electrode AE of the light-emitting element ED and may include an opening exposing the remaining portion of the first electrode AE. A region where the exposed first electrode AE and the light-emitting layer EL overlap (or a region including the same) may be defined as the emission area EA of each pixel PX.

In an embodiment, the pixel defining film PDL may include an organic insulating material. For example, the pixel defining film PDL may include acrylic resin, epoxy resin, phenolic resin, polyamide resin, polyimide resin, unsaturated polyester resin, polyphenylene ether resin, polyphenylenesulfide resin, benzocyclobutene (BCB), or other organic insulating materials.

In an embodiment, the encapsulation layer TFEL may be disposed on the light-emitting element layer EDL, where the encapsulation layer TFEL may cover the light-emitting element layer EDL in the display area DA and may extend to the non-display area NDA to be in contact with the circuit layer CRL. For example, the encapsulation layer TFEL may be disposed in the display area DA to cover the light-emitting element layer EDL, and the end of the encapsulation layer TFEL may be disposed in a portion of the non-display area NDA disposed adjacent to the display area DA. The encapsulation layer TFEL may block the permeation of oxygen or moisture into the light-emitting element layer EDL and may reduce electrical and/or physical impacts to the circuit layer CRL and the light-emitting element layer EDL.

In an embodiment, the encapsulation layer TFEL may be constituted with multiple layers including an inorganic encapsulation layer and an organic encapsulation layer. As an example, the encapsulation layer TFEL may include a first inorganic encapsulation layer, an organic encapsulation layer, and a second inorganic encapsulation layer sequentially disposed on the light-emitting element layer EDL. The encapsulation layer TFEL may be replaced with an encapsulation member of another type or material. For example, the light-emitting element layer EDL may be encapsulated using an upper substrate including an insulating material such as glass.

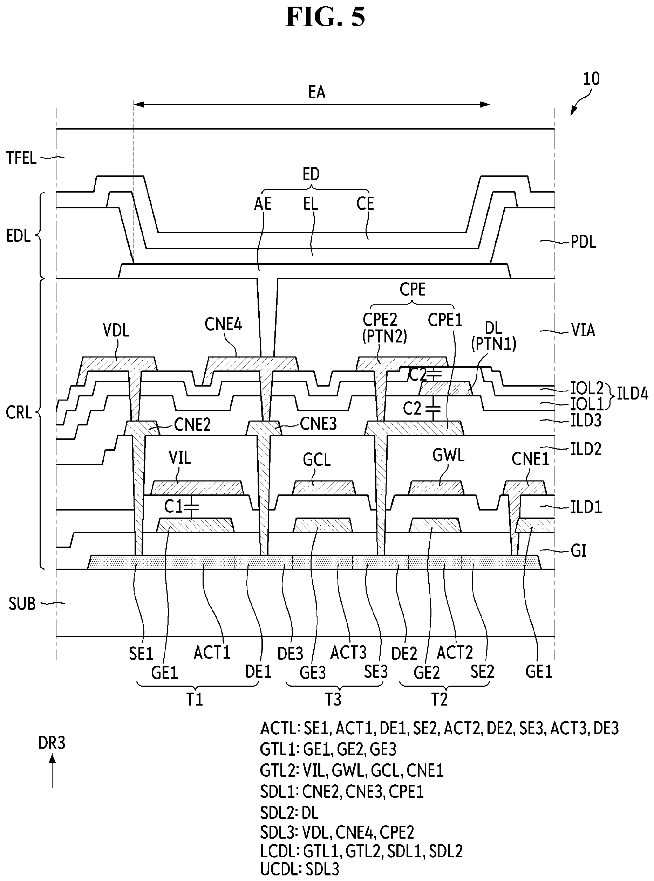

FIG. 5 is a cross-sectional view illustrating a display device, according to an embodiment. For example, FIG. 5 schematically illustrates a cross section of a portion of the display device 10 in which the pixel PX is disposed, according to an embodiment. FIG. 5 illustrates an embodiment that is different from the embodiments of FIGS. 3 and 4 with respect to the pattern shape of the fourth interlayer insulating layer ILD4 and the third source-drain conductive layer SDL3.

In an embodiment and referring to FIG. 5, the first insulating layer may be constituted with multiple layers including at least two inorganic insulating layers. For example, when the first insulating layer is the fourth interlayer insulating layer ILD4, the fourth interlayer insulating layer ILD4 may include a first inorganic insulating layer IOL1 and a second inorganic insulating layer IOL2. The first inorganic insulating layer IOL1 and the second inorganic insulating layer IOL2 may be sequentially stacked along the third direction DR3. For example, the first inorganic insulating layer IOL1 may be disposed on the lower conductive layer LCDL, and the second inorganic insulating layer IOL2 may be disposed on the first inorganic insulating layer IOL1. The first inorganic insulating layer IOL1 and the second inorganic insulating layer IOL2 may include different inorganic insulating materials.

In an embodiment, at least one inorganic insulating layer included in the first insulating layer may be removed to a certain thickness or the entire thickness at a portion in which the first insulating layer and the first pattern PTN1 overlap. For example, when the first insulating layer is the fourth interlayer insulating layer ILD4, the second inorganic insulating layer IOL2 may be etched and removed at a portion in which the fourth interlayer insulating layer ILD4 and the first pattern PTN1 overlap. As an example, the second inorganic insulating layer IOL2 may be formed to protrude to the highest height above the first pattern PTN1, and then may be partially reduced in thickness or opened by being etched at the portion protruding to the highest height. In an embodiment, the primary stepped portion of the second inorganic insulating layer IOL2, which has the highest height level above the first pattern PTN1, may be etched by the entire thickness. Accordingly, the second inorganic insulating layer IOL2 may be opened to expose the first inorganic insulating layer IOL1 above the first pattern PTN1.

In an embodiment, the first inorganic insulating layer IOL1 and the second inorganic insulating layer IOL2 may include materials with different etch selectivities. For example, the first inorganic insulating layer IOL1 may include silicon nitride (SiNₓ), and the second inorganic insulating layer IOL2 may include silicon oxide (SiOₓ). Accordingly, the second inorganic insulating layer IOL2 may be appropriately or easily removed above the first pattern PTN1 through an etching process. Additionally, although the second inorganic insulating layer IOL2 is partially removed, the first pattern PTN1 may be appropriately protected by the first inorganic insulating layer IOL1.

In an embodiment, the first inorganic insulating layer IOL1 may not be substantially etched. Accordingly, the first inorganic insulating layer IOL1 may have the highest height above the first pattern PTN1. For example, the first inorganic insulating layer IOL1 may protrude higher in the third direction DR3 at a portion covering the first pattern PTN1 than at other portions. However, as the second inorganic insulating layer IOL2 is removed from the first pattern PTN1, the stepped portion of the fourth interlayer insulating layer ILD4 may be alleviated or removed.

In an embodiment, the second pattern PTN2 of the upper conductive layer UCDL may be disposed on a portion of the fourth interlayer insulating layer ILD4 including the portion from which the second inorganic insulating layer IOL2 has been removed. Accordingly, the stepped portion of the second pattern PTN2 disposed on the fourth interlayer insulating layer ILD4 may be alleviated or removed, so that the flatness of the second pattern PTN2 may be increased, and the second pattern PTN2 may be stably formed.

Although FIG. 5 discloses an embodiment of planarizing the fourth interlayer insulating layer ILD4 as in the embodiments of FIGS. 3 and 4, the invention is not limited thereto. For example, when it is desired to etch and planarize other insulating layers other than the fourth interlayer insulating layer ILD4, the other insulating layer may be formed of at least a double layer of inorganic insulating layers including different materials, and only an inorganic insulating layer disposed further above other inorganic insulating layers among the inorganic insulating layers may be selectively etched. Accordingly, the stepped portions between the other insulating layers may be alleviated or removed.

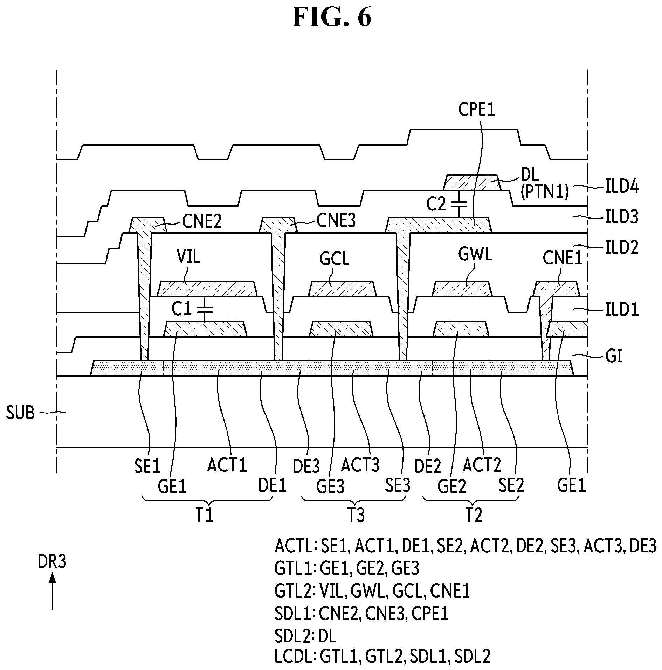

FIGS. 6 to 15 are cross-sectional views showing a method for manufacturing the display device, according to an embodiment. For example, FIGS. 6 to 15 sequentially illustrate manufacturing steps for manufacturing the display device 10 according to the embodiment of FIG. 3.

In an embodiment and referring to FIG. 6, the lower conductive layer LCDL including the first pattern PTN1 (e.g., the data line DL) and the first insulating layer (e.g., the fourth interlayer insulating layer ILD4) covering the lower conductive layer LCDL may be formed on the substrate SUB. For example, the active layer ACTL, the gate insulating layer GI, the first gate conductive layer GTL1, the first interlayer insulating layer ILD1, the second gate conductive layer GTL2, the second interlayer insulating layer ILD2, the first source-drain conductive layer SDL1, the third interlayer insulating layer ILD3, the second source-drain conductive layer SDL2, and the fourth interlayer insulating layer ILD4 may be sequentially formed on the substrate SUB.

In an embodiment, each of the active layer ACTL, the gate insulating layer GI, the first gate conductive layer GTL1, the first interlayer insulating layer ILD1, the second gate conductive layer GTL2, the second interlayer insulating layer ILD2, the first source-drain conductive layer SDL1, the third interlayer insulating layer ILD3, the second source-drain conductive layer SDL2, and the fourth interlayer insulating layer ILD4 may be formed by a film forming process (e.g., deposition process) using the semiconductor material, the insulating material, or a conductive material previously provided as an example as the material of each layer. In forming at least one of the active layer ACTL, the gate insulating layer GI, the first gate conductive layer GTL1, the first interlayer insulating layer ILD1, the second gate conductive layer GTL2, the second interlayer insulating layer ILD2, the first source-drain conductive layer SDL1, the third interlayer insulating layer ILD3, the second source-drain conductive layer SDL2, or the fourth interlayer insulating layer ILD4, when specific shapes of patterns (e.g., electrodes, conductive patterns, and/or wires) and/or contact holes are formed in the semiconductor layer, the insulating layer or the conductive layer, a patterning process (e.g., an etching process or the like using a mask) may be performed after the film forming process to form the patterns and/or the contact holes.

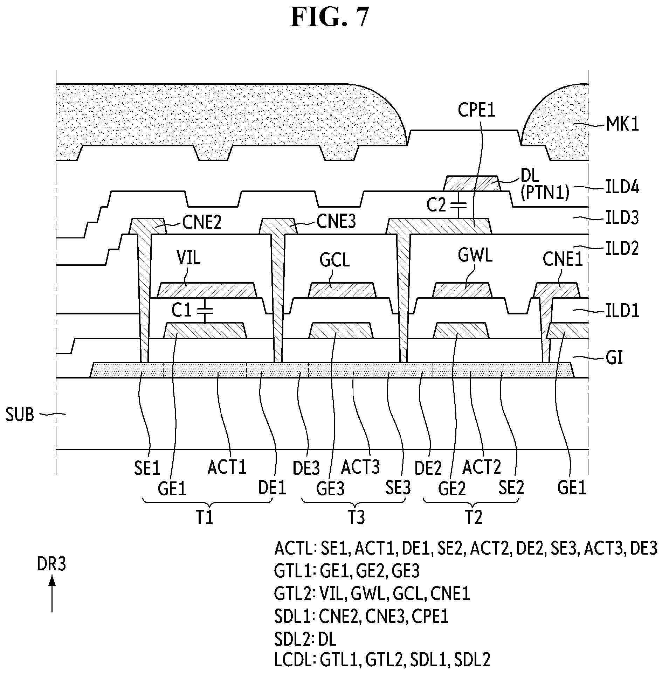

In an embodiment and referring to FIGS. 7 to 12, the first insulating layer may be planarized by etching a portion of the first insulating layer, including the primary stepped portion in which the first insulating layer protrudes to the highest height level, to a certain thickness. For example, a portion of the first insulating layer, including a portion overlapping the first pattern PTN1, may be etched to a certain thickness to planarize the first insulating layer. For example, when it is desired to planarize the fourth interlayer insulating layer ILD4 as the first insulating layer, the fourth interlayer insulating layer ILD4 may be partially etched using at least one mask pattern, so that the fourth interlayer insulating layer ILD4 may be further planarized.

In an embodiment, the first insulating layer may be further planarized as a whole by sequentially etching the primary stepped portion and the secondary stepped portion of the first insulating layer through two mask processes. For example, the primary stepped portion of the first insulating layer, in which the first insulating layer protrudes to the highest height level above the first pattern PTN1 or the like, may be etched, and then, in a state where the primary stepped portion is etched, the secondary stepped portion of the first insulating layer, in which the first insulating layer that protrudes to the highest height level, may be over-etched to form the groove GRV in the first insulating layer. For example, when it is desired to planarize the fourth interlayer insulating layer ILD4 as the first insulating layer, the primary stepped portion and the secondary stepped portion of the fourth interlayer insulating layer ILD4 may be sequentially etched using two mask processes, so that the fourth interlayer insulating layer ILD4 may be further planarized as a whole.

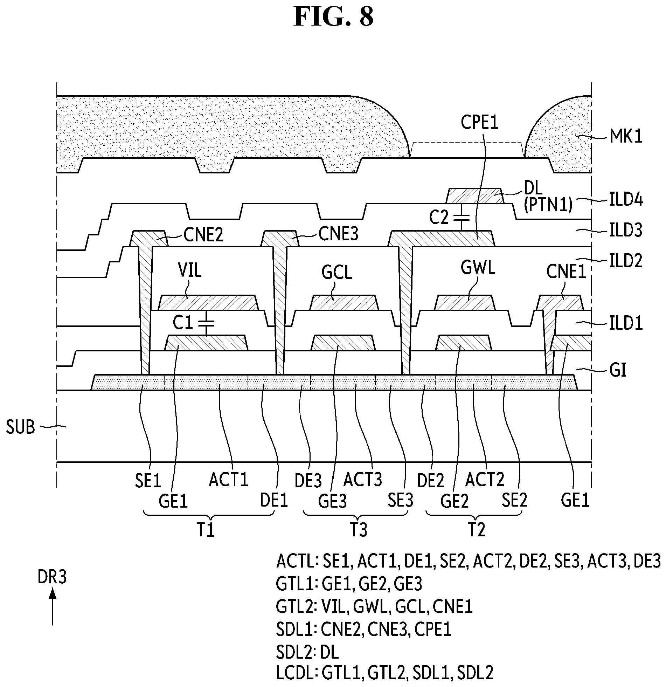

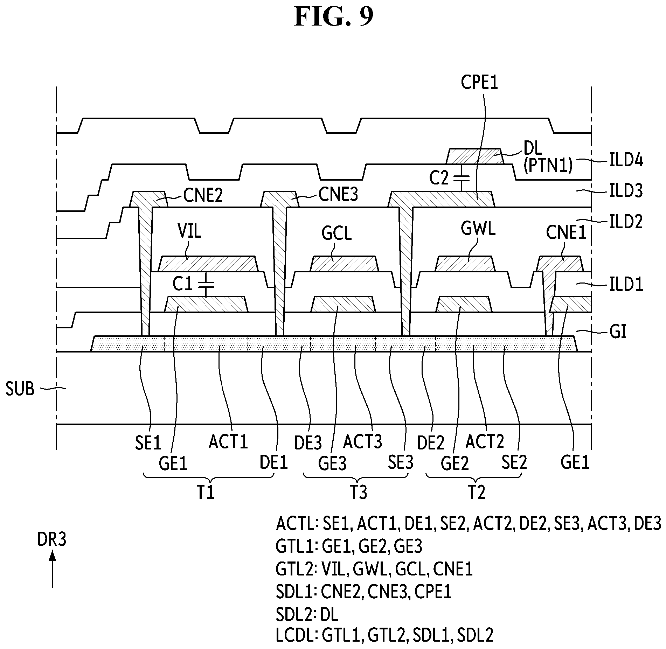

Specifically, in an embodiment, first, as illustrated in FIGS. 7 to 9, by disposing a first mask pattern MK1 on the fourth interlayer insulating layer ILD4 and etching the primary stepped portion of the fourth interlayer insulating layer ILD4 by a dry etching method, the fourth interlayer insulating layer ILD4 may be initially planarized. As illustrated in FIGS. 7 and 8, the first mask pattern MK1 may expose the primary stepped portion of the fourth interlayer insulating layer ILD4 and may cover other portions of the fourth interlayer insulating layer ILD4. As an example, the first mask pattern MK1 may be opened above the first pattern PTN1 at a portion in which the fourth interlayer insulating layer ILD4 protrudes in the third direction DR3 and may cover other portions of the fourth interlayer insulating layer ILD4. The first mask pattern MK1 may be a photoresist pattern, but is not limited thereto. In an embodiment, the etching process using the first mask pattern MK1 may be performed to the extent that the fourth interlayer insulating layer ILD4 is etched to a certain thickness such that the height of the primary stepped portion of the fourth interlayer insulating layer ILD4 is substantially the same or similar to the height of the peripheral area. For example, by an etching process using the first mask pattern MK1, the fourth interlayer insulating layer ILD4 may be etched such that the primary stepped portion has substantially the same height as the secondary stepped portion. After etching of the primary stepped portion of the fourth interlayer insulating layer ILD4 is completed, the first mask pattern MK1 may be removed as illustrated in FIG. 9 by a strip process or the like.

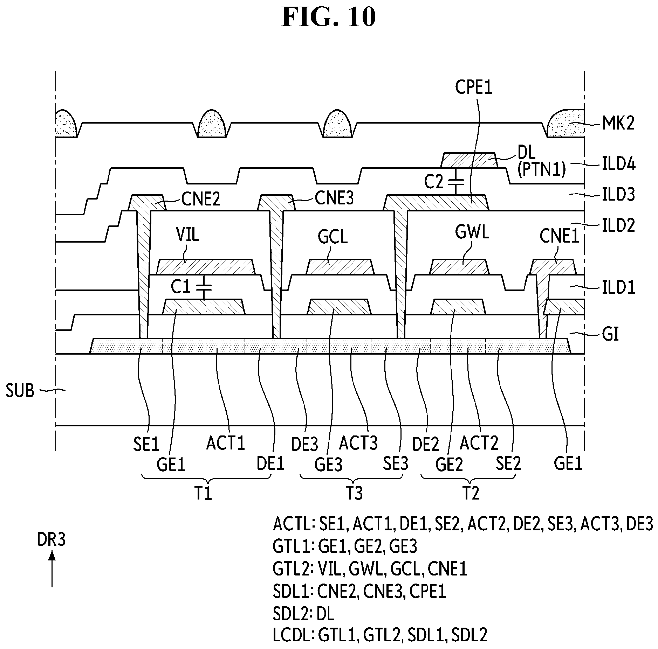

Thereafter, as illustrated in FIGS. 10 to 12 and according to an embodiment, by disposing a second mask pattern MK2 on the fourth interlayer insulating layer ILD4 and etching the secondary stepped portion of the fourth interlayer insulating layer ILD4, the fourth interlayer insulating layer ILD4 may be additionally planarized. For example, by a dry etching method using the second mask pattern MK2 as a mask, the secondary stepped portion of the fourth interlayer insulating layer ILD4 may be etched to a thickness greater than or equal to the height in which the secondary stepped portion of the fourth interlayer insulating layer ILD4 protrudes by other surrounding portions.

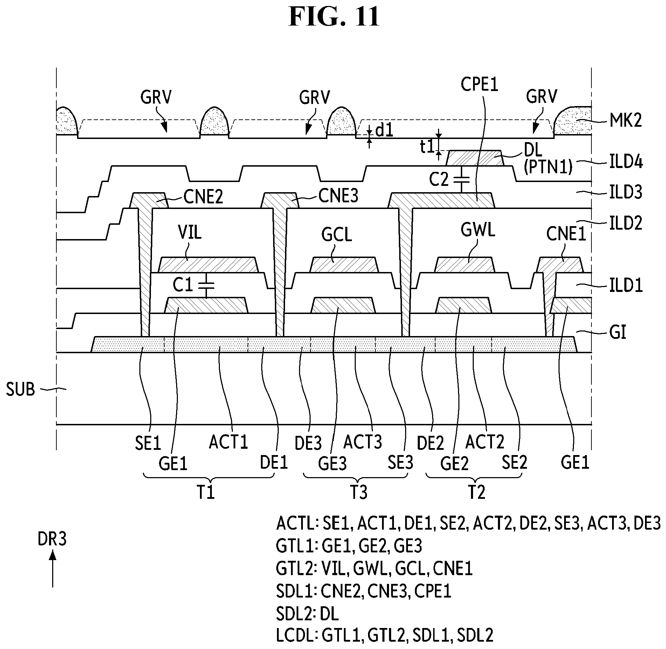

In describing the embodiments, the secondary stepped portion of the fourth interlayer insulating layer ILD4 may mean a portion (e.g., the second highest portion) having a height next to the height of the primary stepped portion of the fourth interlayer insulating layer ILD4 after the film formation of the fourth interlayer insulating layer ILD4 and before the etching thereof. In an embodiment, in the etching process using the first mask pattern MK1, when the primary stepped portion of the fourth interlayer insulating layer ILD4 is etched to a height that is less than or equal to the height of the secondary stepped portion thereof, after the first etching process of the fourth interlayer insulating layer ILD4 is completed, the secondary stepped portion of the fourth interlayer insulating layer ILD4 may be the primary stepped portion of the etched fourth interlayer insulating layer ILD4. As illustrated in FIGS. 10 and 11 and according to an embodiment, the second mask pattern MK2 may expose the secondary stepped portion of the fourth interlayer insulating layer ILD4 and may cover other portions of the fourth interlayer insulating layer ILD4. As an example, the second mask pattern MK2 may be open above the secondary stepped portion of the fourth interlayer insulating layer ILD4 and may cover the remaining portion of the fourth interlayer insulating layer ILD4. The second mask pattern MK2 may be a photoresist pattern, but is not limited thereto. In an embodiment, the etching process using the second mask pattern MK2 may be performed to the extent that the fourth interlayer insulating layer ILD4 is over-etched such that the height of the secondary stepped portion of the fourth interlayer insulating layer ILD4 is lower than the height of the peripheral area (e.g., a portion covered by the second mask pattern MK2). Accordingly, the fourth interlayer insulating layer ILD4 may include the groove GRV recessed lower than the peripheral area in a portion corresponding to the primary stepped portion and the secondary stepped portion at the time of film formation.

In an embodiment, the secondary stepped portion of the fourth interlayer insulating layer ILD4 may be over-etched to be lowered by a depth d1 corresponding to a process margin of approximately 500 Å compared to the peripheral area. Accordingly, the groove GRV may have the depth d1 corresponding to approximately 500 Å. For example, considering process errors, the depth d1 of the groove GRV may have a value in a range of about 200 Å to about 800 Å. The degree of over-etching of the fourth interlayer insulating layer ILD4 or the resulting depth d1 of the groove GRV may vary depending on embodiments.

In an embodiment, even after the etching of the fourth interlayer insulating layer ILD4 is completed, the fourth interlayer insulating layer ILD4 may be etched such that the fourth interlayer insulating layer ILD4 has a minimum thickness of about 500 Å or more. For example, the fourth interlayer insulating layer ILD4 may have a minimum thickness t1 at the upper portion (e.g., between the first pattern PTN1 and the second pattern PTN2) of the first pattern PTN1, and the minimum thickness t1 may be about 500Å. For example, the minimum thickness t1 of the fourth interlayer insulating layer ILD4 may have a value in a range of about 500 Å to about 1000 Å, but is not limited thereto. Accordingly, the fourth interlayer insulating layer ILD4 may ensure the electrical stability of patterns disposed in the second source-drain conductive layer SDL2 and the third source-drain conductive layer SDL3. For example, the first pattern PTN1 and the second pattern PTN2 may be stably insulated by the fourth interlayer insulating layer ILD4 having a minimum thickness of about 500 Å or more to prevent short circuit defects. In case that the minimum thickness (t1) of the fourth interlayer insulating layer (ILD4) is set or controlled in the range of about 500Å to about 1000Å, it is possible to ensure electrical stability between the first pattern (PTN1) and the second pattern (PTN2), while also expanding the range of thickness or degree to which the fourth interlayer insulating layer (ILD4) can be etched.

In an embodiment, the fourth interlayer insulating layer ILD4 may be planarized to have a stepped portion in a range of approximately 3000 Å or less (e.g., about 2500 Å to about 3500 Å). For example, the fourth interlayer insulating layer ILD4 may be entirely planarized such that the maximum stepped portion of the fourth interlayer insulating layer ILD4 is about 3500 Å or less. The degree of planarization (e.g., stepped portion range) of the fourth interlayer insulating layer ILD4 may be set within a range that may stably form the patterns of the upper conductive layer UCDL, and may vary depending on embodiments. As an example, the stepped portion range of the fourth interlayer insulating layer ILD4 may be adjusted within a range in which the patterns of the upper conductive layer UCDL may be stably formed considering the material, thickness, and/or process conditions or the like of the patterns of the upper conductive layer UCDL, and a portion of the fourth interlayer insulating layer ILD4 may be etched correspondingly.

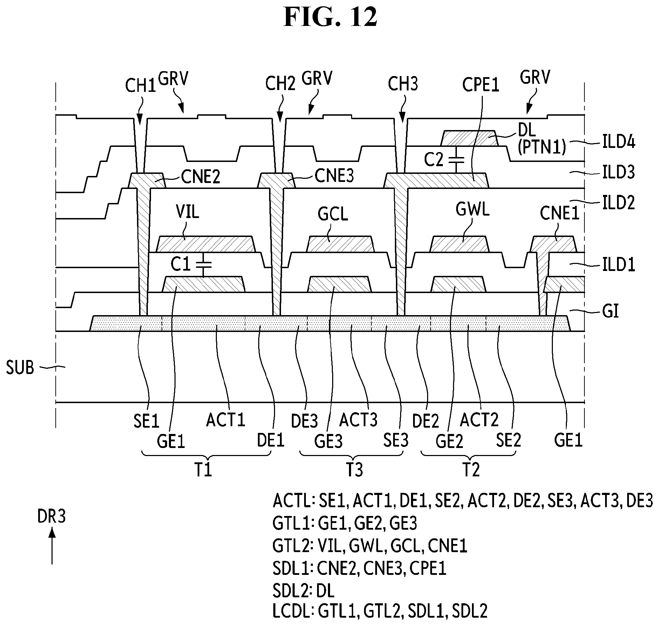

In an embodiment, after the etching process for alleviating or removing the stepped portion of the fourth interlayer insulating layer ILD4 is completed, the second mask pattern MK2 may be removed as illustrated in FIG. 12 by a strip process or the like. Additionally, contact holes may be formed to connect the patterns of the lower conductive layer LCDL to the patterns of the upper conductive layer UCDL. As an example, a first contact hole CH1, a second contact hole CH2, and a third contact hole CH3 that penetrate the third interlayer insulating layer ILD3 and the fourth interlayer insulating layer ILD4 and expose a portion of the second connection electrode CNE2, the third connection electrode CNE3, and the first capacitor electrode CPE1 may be formed.

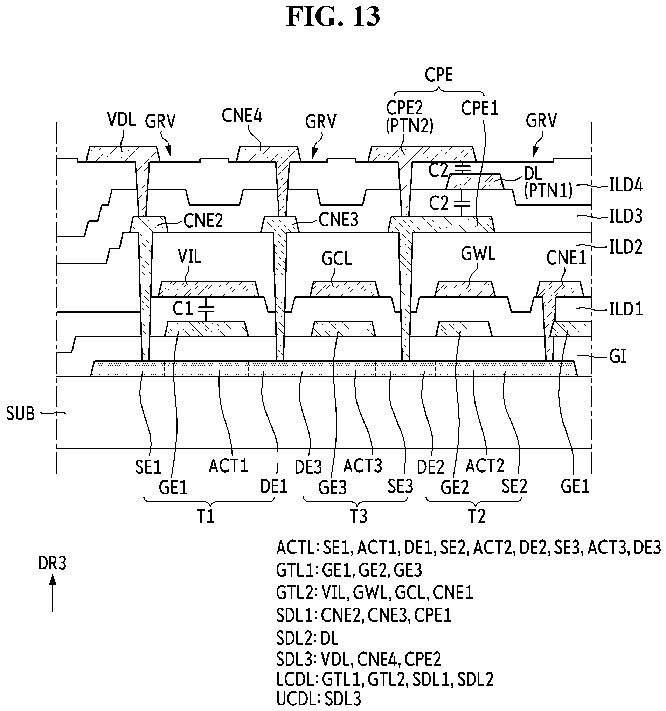

In an embodiment and referring to FIG. 13, the upper conductive layer UCDL including the second pattern PTN2 may be formed on the first insulating layer (e.g., the fourth interlayer insulating layer ILD4) that is further planarized through two etching processes. The second pattern PTN2 may be disposed on the etched portion of the fourth interlayer insulating layer ILD4. As an example, the second pattern PTN2 may overlap the first pattern PTN1 with the etched portion of the fourth interlayer insulating layer ILD4 interposed therebetween.

In an embodiment, the third source-drain conductive layer SDL3 including the second capacitor electrode CPE2 may be formed on the fourth interlayer insulating layer ILD4. The second capacitor electrode CPE2 may be disposed on the groove GRV of the fourth interlayer insulating layer ILD4 and may overlap the data line DL with a portion of the fourth interlayer insulating layer ILD4 including the groove GRV interposed therebetween.

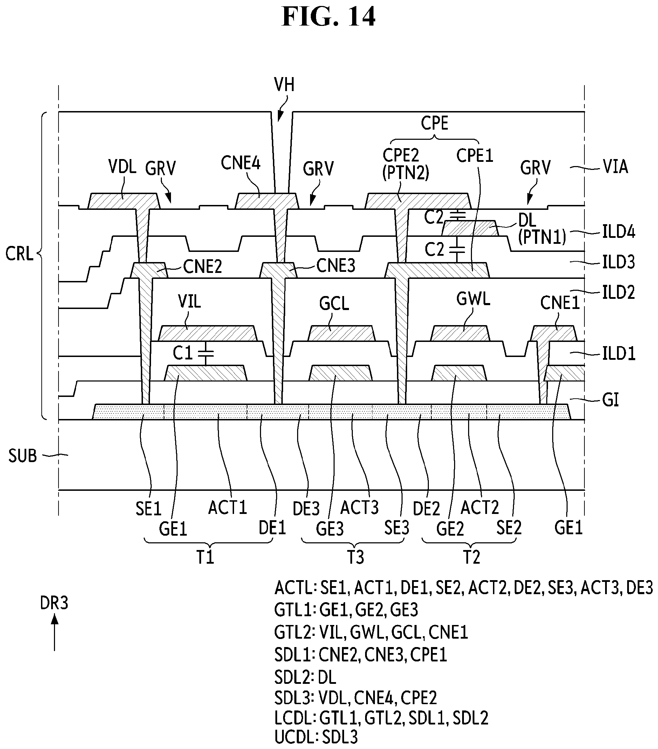

In an embodiment and referring to FIG. 14, the second insulating layer may be formed on the upper conductive layer UCDL. For example, the upper insulating layer VIA covering the third source-drain conductive layer SDL3 may be formed on the fourth interlayer insulating layer ILD4. Additionally, via holes VH may be formed to connect the patterns of the circuit layer CRL to the light-emitting elements ED of the light-emitting element layer EDL. For example, in each pixel area, the via holes VH may be formed that penetrate the upper insulating layer VIA and expose a part of the fourth connection electrode CNE4.

Through the process described above with reference to FIGS. 6 to 14, the circuit layer CRL may be formed on the substrate SUB, according to an embodiment.

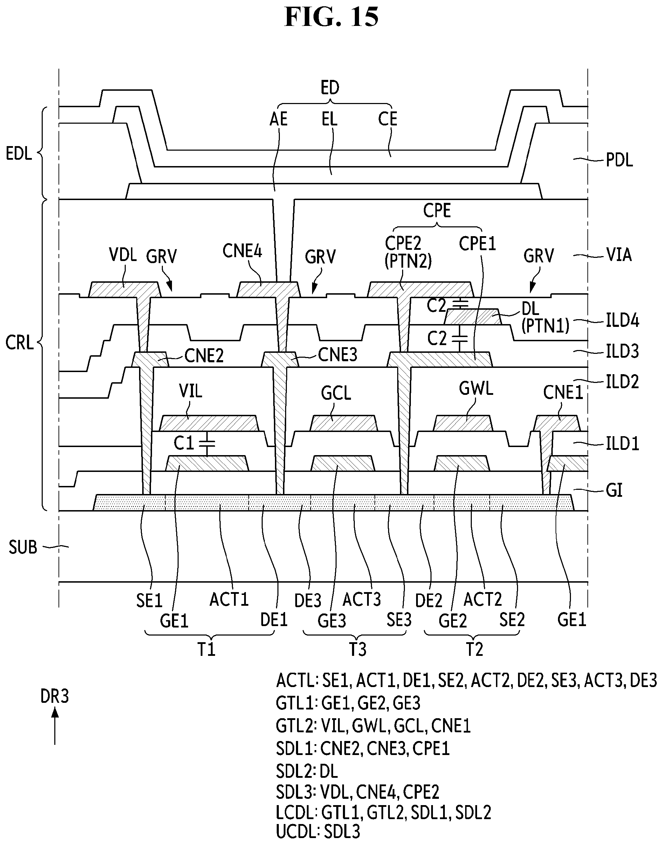

In an embodiment and referring to FIG. 15, the light-emitting element layer EDL including the light-emitting element ED may be formed on the circuit layer CRL. For example, the first electrode AE of the light-emitting element ED, the pixel defining film PDL, the light-emitting layer EL of the light-emitting element ED, and the second electrode CE of the light-emitting element ED may be sequentially formed on the upper insulating layer VIA.

Afterwards, an encapsulation process may be performed to protect the light-emitting element layer EDL, or the like. For example, when the light-emitting element layer EDL is encapsulated with the encapsulation layer TFEL as in the embodiment of FIG. 3, the encapsulation layer TFEL may be formed on the light-emitting element layer EDL. Thus, the display device 10, according to the embodiment of FIG. 3, may be manufactured.

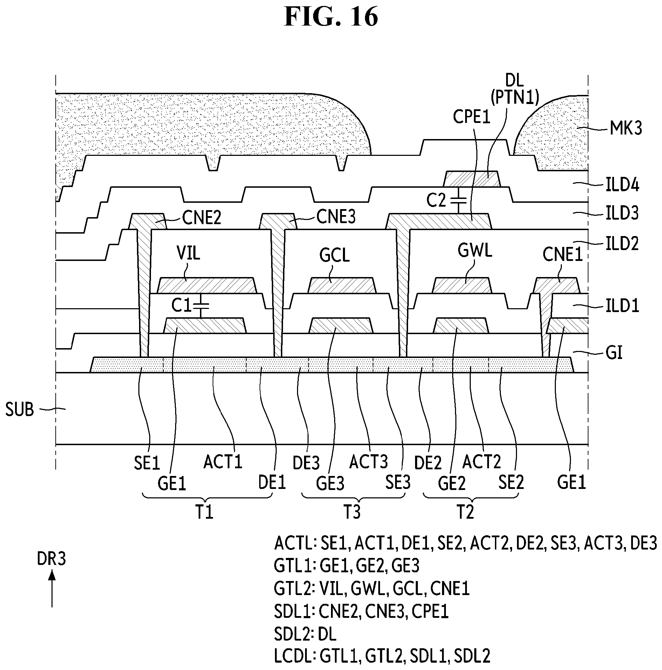

FIGS. 16 to 19 are cross-sectional views showing a method for manufacturing the display device, according to an embodiment. For example, FIGS. 16 to 19 sequentially illustrate manufacturing steps for manufacturing the display device 10 according to the embodiment of FIG. 4.

In manufacturing the display device 10, according to the embodiment of FIG. 4, a process or a method of forming the lower conductive layer LCDL including the first pattern PTN1 (e.g., the data line DL) and the first insulating layer (e.g., the fourth interlayer insulating layer ILD4) covering the lower conductive layer LCDL may be substantially the same as the embodiment described with reference to FIG. 6. Accordingly, redundant description will be omitted.

In an embodiment and referring to FIGS. 16 to 18, the first insulating layer may be planarized by etching a portion of the first insulating layer, including the primary stepped portion in which the first insulating layer protrudes to the highest height, to a certain thickness. In an embodiment, the primary stepped portion of the first insulating layer may be stably removed by over-etching a portion of the first insulating layer including the primary stepped portion to a height less than or equal to the height of other surrounding portions. Accordingly, the groove GRV may be formed in the first insulating layer.

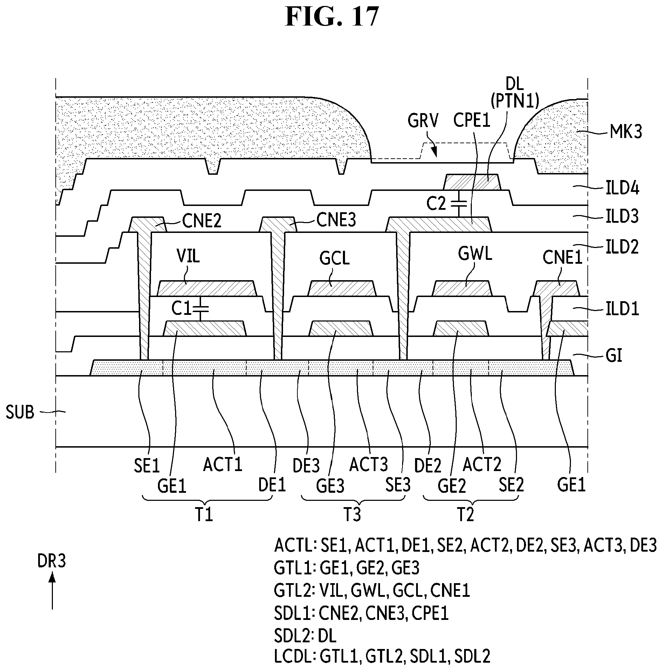

In an embodiment, when it is desired to planarize the fourth interlayer insulating layer ILD4 as the first insulating layer, the fourth interlayer insulating layer ILD4 may be planarized by etching a portion of the fourth interlayer insulating layer ILD4 including the primary stepped portion of the fourth interlayer insulating layer ILD4, which protrudes to the highest height level above the first pattern PTN1, to a certain thickness. For example, as illustrated in FIGS. 16 and 17, by disposing a third mask pattern MK3 (also referred to as "mask pattern") on the fourth interlayer insulating layer ILD4 and partially etching the fourth interlayer insulating layer ILD4 by a dry etching method, the fourth interlayer insulating layer ILD4 may be further planarized. The third mask pattern MK3 may be a photoresist pattern, but is not limited thereto.

In an embodiment, the third mask pattern MK3 may expose a portion of the fourth interlayer insulating layer ILD4 including the primary stepped portion of the fourth interlayer insulating layer ILD4 above the first pattern PTN1 and a portion of the secondary stepped portion positioned around the primary stepped portion and may cover other portions of the fourth interlayer insulating layer ILD4. Accordingly, the fourth interlayer insulating layer ILD4 may be etched in a form in which the thickness is reduced in a portion of the fourth interlayer insulating layer ILD4 including the primary stepped portion and a portion of the secondary stepped portion around the primary stepped portion.

In an embodiment, as illustrated in FIG. 17, the fourth interlayer insulating layer ILD4 may be over-etched such that the height of the exposed portion of the fourth interlayer insulating layer ILD4 above the first pattern PTN1 is lower than the height of the peripheral area. Accordingly, the groove GRV may be formed in the fourth interlayer insulating layer ILD4. In an embodiment, over-etching may be performed to be lowered to a level equal to a depth (e.g., d1 in FIG. 11) corresponding to a process margin of approximately 500 Å of the fourth interlayer insulating layer ILD4. Accordingly, the groove GRV may have a depth corresponding to approximately 500 Å. For example, considering process errors, the depth of the groove GRV may have a value in a range of about 200 Å to about 800 Å. The degree of over-etching of the fourth interlayer insulating layer ILD4 or the depth of the groove GRV may vary depending on embodiments.

In an embodiment, the fourth interlayer insulating layer ILD4 may be etched such that the fourth interlayer insulating layer ILD4 has a minimum thickness of about 500 Å or more. As an example, the fourth interlayer insulating layer ILD4 may have a thickness of about 500 Å or more (e.g., t1 in FIG. 11) even above the first pattern PTN1. In an embodiment, the minimum thickness of the fourth interlayer insulating layer ILD4 may have a value in a range of about 500 Å to about 1000 Å, but is not limited thereto. Accordingly, the electrical stability of the patterns disposed in the second source-drain conductive layer SDL2 disposed under the fourth interlayer insulating layer ILD4 and the third source-drain conductive layer SDL3 disposed above the fourth interlayer insulating layer ILD4 may be ensured.

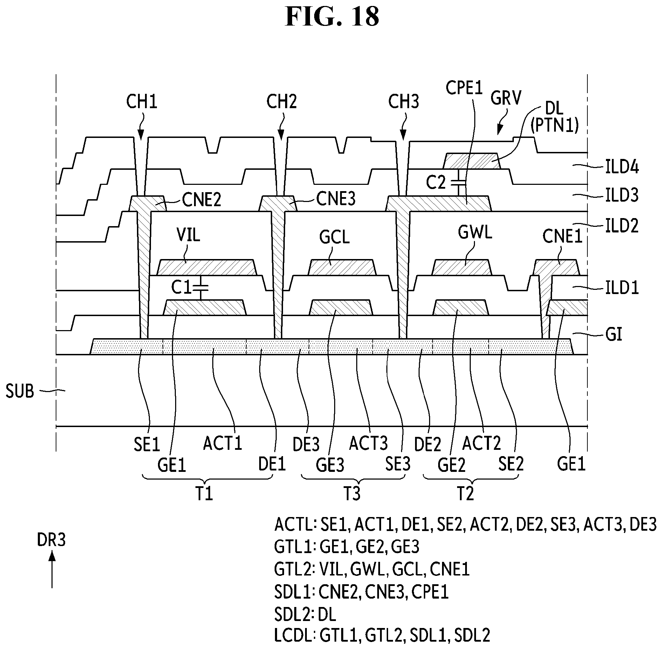

After the etching process for alleviating or removing the stepped portion of the fourth interlayer insulating layer ILD4 is completed, the third mask pattern MK3 may be removed as illustrated in FIG. 18 by a strip process or the like. In addition, contact holes (e.g., the first contact hole CH1, the second contact hole CH2, and the third contact hole CH3) for connecting the patterns of the lower conductive layer LCDL to the patterns of the upper conductive layer UCDL may be formed.

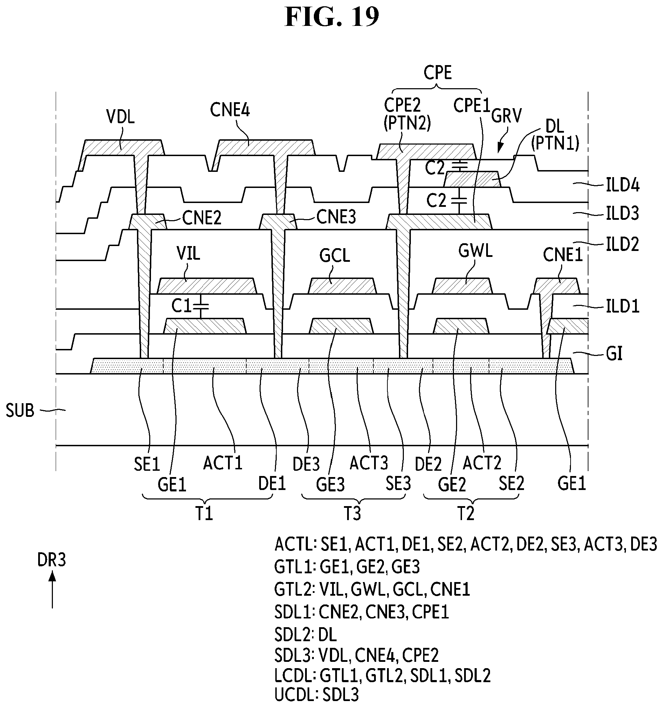

In an embodiment and referring to FIG. 19, the upper conductive layer UCDL including the second pattern PTN2 may be formed on the fourth interlayer insulating layer ILD4 that is further planarized through an etching process. For example, the third source-drain conductive layer SDL3 may be formed on the fourth interlayer insulating layer ILD4. The third source-drain conductive layer SDL3 may include the second capacitor electrode CPE2 disposed on the groove GRV of the fourth interlayer insulating layer ILD4. The second capacitor electrode CPE2 may overlap the data line DL with the fourth interlayer insulating layer ILD4 interposed therebetween.

Afterwards, the second insulating layer covering the upper conductive layer UCDL may be formed. For example, the upper insulating layer VIA, the light-emitting element layer EDL, the encapsulation layer TFEL, and the like of FIG. 4 may be formed on the fourth interlayer insulating layer ILD4. Thus, the display device 10 according to the embodiment of FIG. 4 may be manufactured.

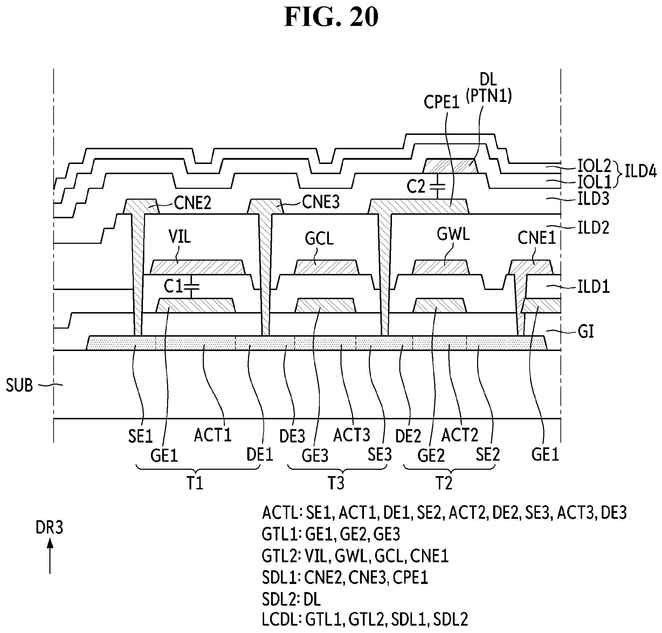

FIGS. 20 to 24 are cross-sectional views showing a method for manufacturing the display device, according to one embodiment. For example, FIGS. 20 to 24 sequentially illustrate manufacturing steps for manufacturing the display device 10 according to the embodiment of FIG. 5.

In manufacturing the display device 10, according to the embodiment of FIG. 5, a process or a method of forming the lower conductive layer LCDL including the first pattern PTN1 may be substantially the same as the process or the method of forming the lower conductive layer LCDL in the step of manufacturing the display device 10, according to the embodiments of FIGS. 3 and 4. Accordingly, redundant description will be omitted.

In an embodiment and referring to FIG. 20, the first insulating layer covering the lower conductive layer LCDL may be formed on the lower conductive layer LCDL including the first pattern PTN1. For example, the fourth interlayer insulating layer ILD4 may be formed on the second source-drain conductive layer SDL2 including the data line DL.

In an embodiment, the first inorganic insulating layer IOL1 and the second inorganic insulating layer IOL2 including different materials from each other may be sequentially formed on the lower conductive layer LCDL. For example, the first inorganic insulating layer IOL1 may be formed on the second source-drain conductive layer SDL2 using silicon nitride, and the second inorganic insulating layer IOL2 may be formed on the first inorganic insulating layer IOL1 using silicon oxide. Accordingly, the fourth interlayer insulating layer ILD4 including the first inorganic insulating layer IOL1 and the second inorganic insulating layer IOL2 may be formed.

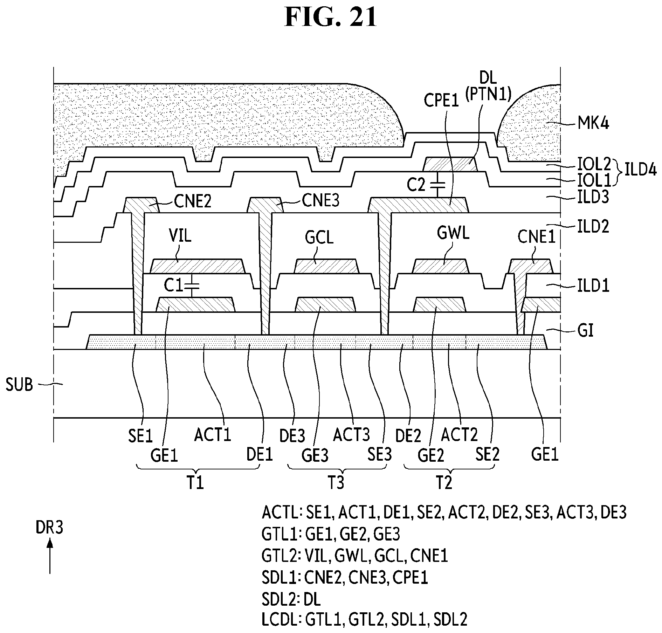

In an embodiment and referring to FIGS. 21 to 23, the first insulating layer may be planarized by etching a portion of the first insulating layer, including the primary stepped portion in which the first insulating layer protrudes to the highest height, to a certain thickness. For example, when it is desired to planarize the fourth interlayer insulating layer ILD4 as the first insulating layer, the fourth interlayer insulating layer ILD4 may be planarized by etching the fourth interlayer insulating layer ILD4 to a certain thickness at the primary stepped portion of the fourth interlayer insulating layer ILD4, which protrudes to the highest height above the first pattern PTN1.

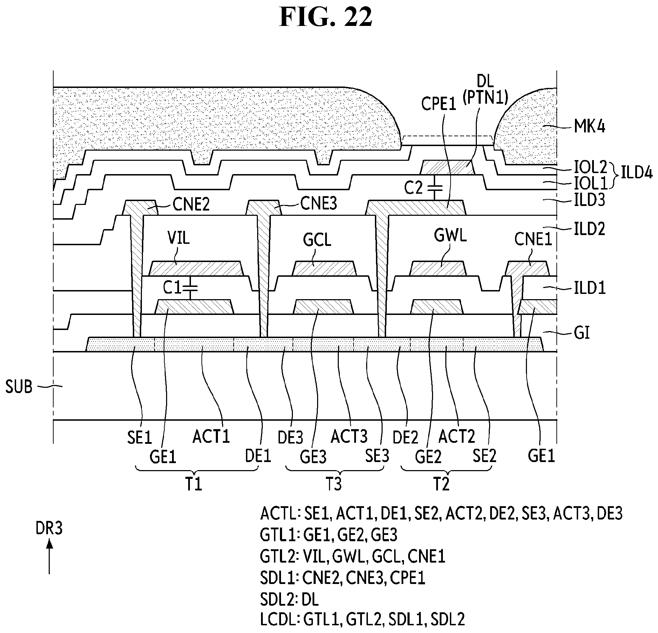

For example, according to an embodiment and as illustrated in FIGS. 21 and 22, a fourth mask pattern MK4 (also referred to as "mask pattern") may be disposed on the fourth interlayer insulating layer ILD4, and the second inorganic insulating layer IOL2 of the fourth interlayer insulating layer ILD4 may be etched at a portion in which the fourth mask pattern MK4 is opened by a dry etching method. Accordingly, the fourth interlayer insulating layer ILD4 may be further planarized. The fourth mask pattern MK4 may be a photoresist pattern, but is not limited thereto.

In an embodiment, since the first inorganic insulating layer IOL1 and the second inorganic insulating layer IOL2 include different materials from each other, only the second inorganic insulating layer IOL2 may be selectively etched and removed by using the difference in the selective etch ratios of the first inorganic insulating layer IOL1 and the second inorganic insulating layer IOL2. Accordingly, the fourth interlayer insulating layer ILD4 may have a thickness reduced by the thickness of the second inorganic insulating layer IOL2 above the first pattern PTN1.

In an embodiment, the first inorganic insulating layer IOL1 may be formed to have a thickness of about 500 Å or more. Accordingly, although the second inorganic insulating layer IOL2 is etched and removed above the first pattern PTN1, the electrical stability of the patterns disposed in the second source-drain conductive layer SDL2 and the third source-drain conductive layer SDL3 may be ensured by the first inorganic insulating layer IOL1.

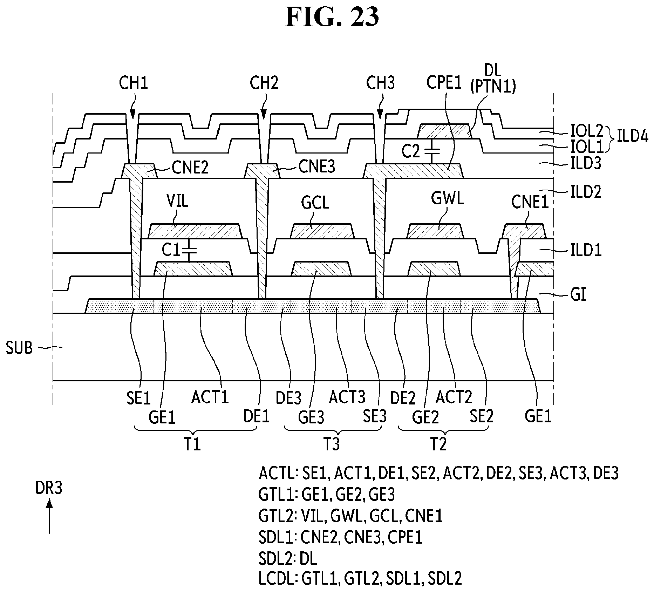

After the etching process for alleviating or removing the stepped portion of the fourth interlayer insulating layer ILD4 is completed, the fourth mask pattern MK4 may be removed by a strip process or the like, as illustrated in FIG. 23. In addition, contact holes (e.g., the first contact hole CH1, the second contact hole CH2, and the third contact hole CH3) for connecting the patterns of the lower conductive layer LCDL to the patterns of the upper conductive layer UCDL may be formed.

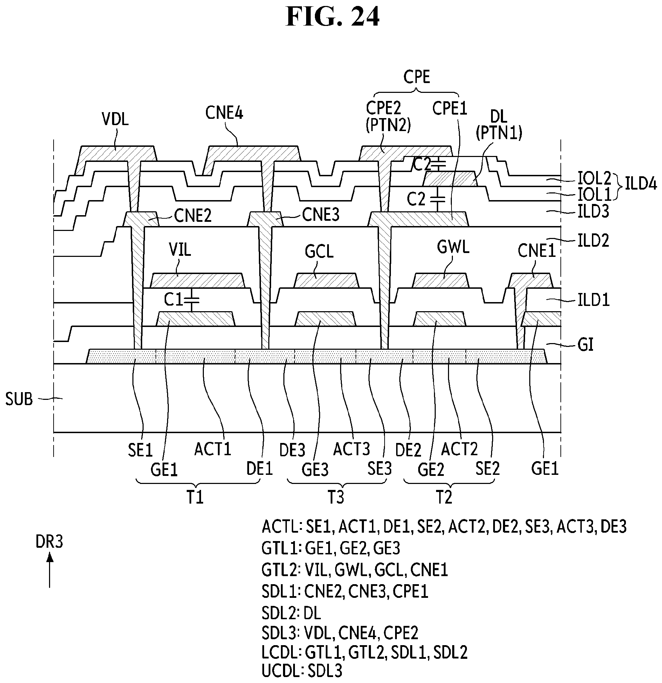

In an embodiment and referring to FIG. 24, the upper conductive layer UCDL including the second pattern PTN2 may be formed on the fourth interlayer insulating layer ILD4 that is further planarized through an etching process. For example, the third source-drain conductive layer SDL3 may be formed on the fourth interlayer insulating layer ILD4. The third source-drain conductive layer SDL3 may include the second capacitor electrode CPE2 disposed on a portion in which the thickness of the fourth interlayer insulating layer ILD4 is reduced by etching the second inorganic insulating layer IOL2. The second capacitor electrode CPE2 may overlap the data line DL with the fourth interlayer insulating layer ILD4 interposed therebetween.

Afterwards, the second insulating layer covering the upper conductive layer UCDL may be formed. For example, the upper insulating layer VIA, the light-emitting element layer EDL, the encapsulation layer TFEL, and the like of FIG. 5 may be formed on the fourth interlayer insulating layer ILD4. Thus, the display device 10 according to the embodiment of FIG. 5 may be manufactured.

As described above, according to the display device 10, according to an embodiment and the manufacturing method thereof, pattern defects in the conductive layer such as disconnection or short circuit may be prevented. For example, the first insulating layer covering the lower patterns including the first pattern PTN1 may be planarized such that the height is reduced in a portion including the primary stepped portion. As an example, the fourth interlayer insulating layer ILD4 covering the lower patterns including the first pattern PTN1 and disposed in the lower conductive layer LCDL may be etched to a certain thickness at a portion or the like that protrudes to the highest height as in the upper portion of the first pattern PTN1 and may be planarized. As a result, it is possible to alleviate or prevent the stepped portion between the upper patterns formed on the first insulating layer and prevent disconnection defects in the upper patterns. For example, the upper patterns disposed in the upper conductive layer UCDL on the fourth interlayer insulating layer ILD4, including the second pattern PTN2, may be formed to be relatively flat. Accordingly, the upper patterns may be stably formed, and disconnection defects of the upper patterns may be prevented.

Additionally, according to the display device 10, according to an embodiment and the manufacturing method thereof, the first insulating layer may be partially etched and planarized by an etching process using at least one mask pattern. For example, the fourth interlayer insulating layer ILD4 may be etched to a thickness or a depth in a target range at a portion including the primary stepped portion by at least one dry etching process using at least one mask pattern.

According to an embodiment, the first insulating layer may be appropriately planarized without performing a CMP process, and the degree of etching of the first insulating layer may be appropriately or easily controlled. Accordingly, it is possible to prevent or reduce excessive etching or polishing of the first insulating layer or generation of foreign matter during the planarization process, to increase the electrical stability of the circuit layer CRL including the lower conductive layer LCDL, a first insulating layer on the lower conductive layer LCDL, and the upper conductive layer UCDL on the first insulating layer, and to prevent short circuit defects from occurring in the circuit layer CRL.

According to an embodiment, even in the high-resolution display device 10 with a high density of patterns disposed in the circuit layer CRL, for example, the display device 10 with a resolution of 1500 PPI or more, pattern defects such as disconnection or short circuit may be effectively prevented. Accordingly, defects in the display device 10 may be improved, and yield may be increased.

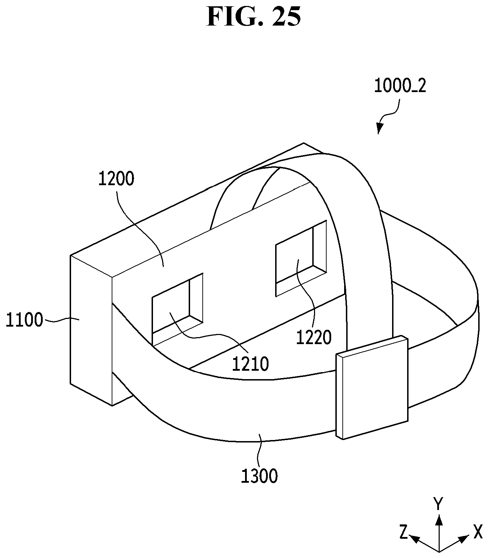

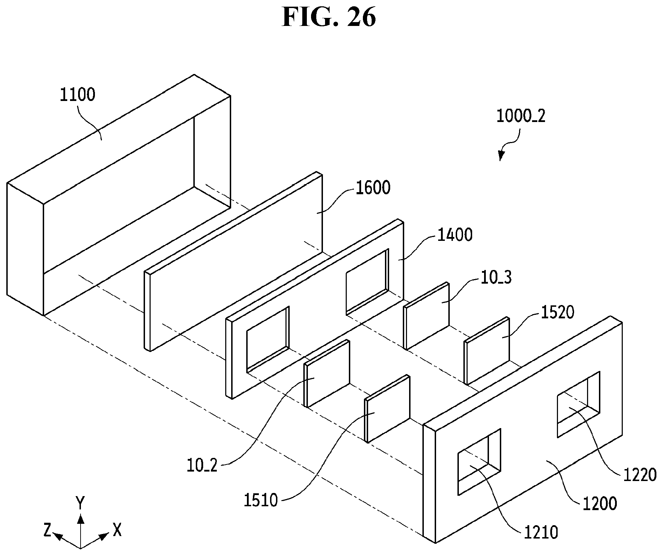

FIGS. 25 and 26 are diagrams illustrating a virtual reality device including a display device, according to an embodiment.

**In** an embodiment and referring to FIGS. 25 and 26, the virtual reality device may be a head mounted display device 1000_2. The head mounted display device 1000_2 includes a first display device 10_2, a second display device 10_3, a display device housing 1100, a housing cover 1200, a first eyepiece 1210, a second eyepiece 1220, a head mounted band 1300, a middle frame 1400, a first optical member 1510, a second optical member 1520, and a control circuit board 1600.

The first display device 10_2 provides an image to the user's left eye, and the second display device 10_3 provides an image to the user's right eye, where each of the first display device 10_2 and the second display device 10_3 may be the display device 10 according to the embodiments described above.

The first optical member 1510 may be disposed between the first display device 10_2 and the first eyepiece 1210. The second optical member 1520 may be disposed between the second display device 10_3 and the second eyepiece 1220. Each of the first optical member 1510 and the second optical member 1520 may include at least one convex lens.

The middle frame 1400 may be disposed between the first display device 10_2 and the control circuit board 1600 and between the second display device 10_3 and the control circuit board 1600, where the middle frame 1400 serves to support and fix the first display device 10_2, the second display device 10_3, and the control circuit board 1600.

The control circuit board 1600 may be disposed between the middle frame 1400 and the display device housing 1100. The control circuit board 1600 may be connected to the first display device 10_2 and the second display device 10_3 through the connector. The control circuit board 1600 may convert an image source inputted from the outside into video data DATA and transmit the video data DATA to the first display device 10_2 and the second display device 10_3 through the connector.

The control circuit board 1600 may transmit the video data DATA corresponding to a left-eye image optimized for the user's left eye to the first display device 10_2 and may transmit the video data DATA corresponding to a right-eye image optimized for the user's right eye to the second display device 10_3. In an embodiment, the control circuit board 1600 may transmit the same video data DATA to the first display device 10_2 and the second display device 10_3.

The display device housing 1100 serves to accommodate the first display device 10_2, the second display device 10_3, the middle frame 1400, the first optical member 1510, the second optical member 1520, and the control circuit board 1600. The housing cover 1200 is disposed to cover one open surface of the display device housing 1100. The housing cover 1200 may include the first eyepiece 1210 at which the user's left eye is located and the second eyepiece 1220 at which the user's right eye is located. FIGS. 25 and 26 illustrate that the first eyepiece 1210 and the second eyepiece 1220 are disposed separately, but the present disclosure is not limited thereto. The first eyepiece 1210 and the second eyepiece 1220 may be combined into one.

The first eyepiece 1210 may be aligned with the first display device 10_2 and the first optical member 1510, and the second eyepiece 1220 may be aligned with the second display device 10_3 and the second optical member 1520. Therefore, the user may view, through the first eyepiece 1210, the image of the first display device 10_2 magnified as a virtual image by the first optical member 1510, and may view, through the second eyepiece 1220, the image of the second display device 10_3 magnified as a virtual image by the second optical member 1520.

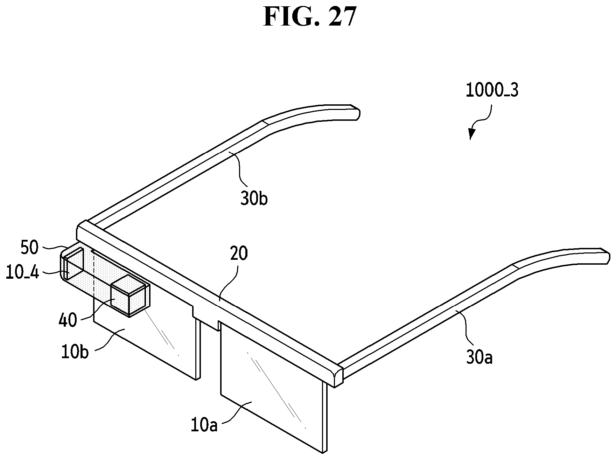

The head mounted band 1300 serves to secure the display device housing 1100 to the user's head such that the first eyepiece 1210 and the second eyepiece 1220 of the housing cover 1200 remain located on the user's left and right eyes, respectively. When the display device housing 1100 is implemented to be lightweight and compact, the head mounted display device 1000_2 may be provided with, as shown in FIG. 27, an eyeglass frame instead of the head mounted band 1300.

In addition, the head mounted display device 1000_2 may further include a battery for supplying power, an external memory slot for accommodating an external memory, and an external connection port and a wireless communication module for receiving an image source. The external connection port may be a universe serial bus (USB) terminal, a display port, or a high-definition multimedia interface (HDMI) terminal, and the wireless communication module may be a 5G communication module, a 4G communication module, a Wi-Fi module, or a Bluetooth module.

FIG. 27 is a diagram illustrating a virtual reality device including a display device, according to an embodiment. For example, FIG. 27 shows a virtual reality device 1000_3 to which a display device 10_4, according to an embodiment is applied.

In an embodiment and referring to FIG. 27, the virtual reality device 1000_3 may be a glasses-type device. The virtual reality device 1000_3, according to an embodiment, may include the display device 10_4, a left eye lens 10a, a right eye lens 10b, a support frame 20, temples 30a and 30b, a reflection member 40, and a display device housing 50.

FIG. 27 illustrates an embodiment where the virtual reality device 1000_3 may be a glasses-type display device including the temples 30a and 30b. That is, the virtual reality device 1000_3, according to an embodiment, is not limited to that shown in FIG. 27 and may be applied in various forms to various electronic devices.

The display device housing 50 may include the display device 10_4 and the reflection member 40. An image displayed on the display device 10_4 may be reflected by the reflection member 40 and provided to the user's right eye through the right eye lens 10b. As a result, the user may view a virtual reality image displayed on the display device 10_4 with the right eye. The display device 10_4 may be the display device 10, according to the embodiments described above.

Although FIG. 27 illustrates that the display device housing 50 is disposed at the right end of the support frame 20, the invention is not limited thereto. For example, in another embodiment, the display device housing 50 may be disposed at the left end of the support frame 20, and in this case, the image displayed on the display device 10_4 may be reflected by the reflection member 40 and provided to a user's left eye through the left eye lens 10a. As a result, the user may view a virtual reality image displayed on the display device 10_4 with the left eye. In another embodiment, the display device housing 50 may be disposed at both the left end and the right end of the support frame 20. In that case, the user can view the virtual reality image displayed on the display device 10_4 through both the left eye and the right eye.

FIGS. 25 to 27 illustrate embodiments in which the display device 10, according to the above-described embodiments, is applied to a virtual reality device, but the invention is not limited thereto. For example, the display device 10, according to other embodiments, may be applied to or included in other types of electronic devices.

It will be understood by one of ordinary skill in the art to which the invention belongs that the invention may be implemented in other specific embodiments than those described herein without changing the technical scope or essential features of the invention. Therefore, it is to be understood that the example embodiments described above are illustrative rather than being restrictive in all aspects. The disclosed embodiments of the invention are used in a generic and descriptive sense only and not for purposes of limitation. Each component specifically shown in the embodiments of the invention can be implemented by modification, and such modifications and differences related to invention should be construed as being included in the scope of the invention. Moreover, the embodiments or parts of the embodiments may be combined in whole or in part without departing from the scope of the invention.

## Claims

1. A display device comprising:
a substrate; and
a circuit layer comprising circuit elements and wires disposed on the substrate,
wherein the circuit layer comprises:
a lower conductive layer disposed on the substrate and comprising a first pattern;
a first insulating layer disposed on the lower conductive layer, and comprising a groove disposed on a portion of the first insulating layer comprising a first portion having a reduced thickness and that is covering the first pattern;
an upper conductive layer disposed on the first insulating layer, and comprising a second pattern disposed on the groove; and
a second insulating layer covering the upper conductive layer.

2. The display device of claim 1, wherein the first insulating layer is a single-layer inorganic insulating layer or a multilayer inorganic insulating layer.

3. The display device of claim 2, wherein other portions of the first insulating layer other than the first portion have stepped portions corresponding to patterns of the lower conductive layer.

4. The display device of any of claims 1 to 3, wherein a depth of the groove ranges from about 200 Å to about 800 Å.

5. The display device of any preceding claim, wherein the first insulating layer has a thickness of about 500 Å to about 1000 Å between the first pattern and the second pattern.

6. The display device of any preceding claim, wherein the lower conductive layer comprises a plurality of conductive layers comprising at least one electrode among electrodes included in the circuit elements and at least one wire among the wires.

7. The display device of claim 6, wherein the upper conductive layer comprises at least one conductive layer disposed on the plurality of conductive layers; optionally:
wherein the upper conductive layer is a conductive layer disposed at an uppermost portion among the conductive layers included in the circuit layer.

8. The display device of any preceding claim, further comprising a light-emitting element layer disposed on the circuit layer, the light-emitting element layer comprising a light-emitting element electrically connected to the circuit elements.

9. A display device comprising:
a substrate; and
a circuit layer comprising circuit elements and wires disposed on the substrate,
wherein the circuit layer comprises:
a lower conductive layer disposed on the substrate, and comprising a first pattern;
a first insulating layer including a first inorganic insulating layer disposed on the lower conductive layer and a second inorganic insulating layer disposed on the first inorganic insulating layer, wherein the second inorganic insulating layer is removed from a portion of the first inorganic insulating layer that is overlapping the first pattern;
an upper conductive layer comprising a second pattern disposed on a portion of the first insulating layer including a portion from which the second inorganic insulating layer has been removed; and
a second insulating layer covering the upper conductive layer.

10. The display device of claim 9, wherein the first inorganic insulating layer and the second inorganic insulating layer contain different inorganic insulating materials; optionally:
wherein the first inorganic insulating layer contains silicon nitride, and
the second inorganic insulating layer contains silicon oxide.

11. The display device of claim 9 or claim 10, wherein:
(i) the first inorganic insulating layer includes a portion of the first inorganic insulating layer that is disposed at a highest level above the first pattern; and/or
(ii) the display device further comprises a light-emitting element layer disposed on the circuit layer, the light-emitting element layer comprising a light-emitting element electrically connected to the circuit elements.

12. A method for manufacturing a display device, comprising:
forming, on a substrate, a lower conductive layer including a first pattern and a first insulating layer covering the lower conductive layer;
planarizing the first insulating layer by etching a portion of the first insulating layer that overlaps the first pattern to a predetermined thickness; and
forming, on the first insulating layer, an upper conductive layer including a second pattern disposed on the portion of the first insulating layer that overlaps the first pattern.

13. The method of claim 12, wherein:
(i) the planarizing of the first insulating layer includes dry etching the portion of the first insulating layer using at least one mask pattern; and/or
(ii) the planarizing of the first insulating layer comprises:
etching a primary stepped portion of the first insulating layer in which the first insulating layer includes a portion of the first insulating layer that is disposed at a highest level above the first pattern; and
forming a groove in the first insulating layer by over-etching a secondary stepped portion of the first insulating layer, wherein the first insulating layer includes a portion disposed at a highest level in a state where the primary stepped portion is etched.

14. The method of claim 12 or claim 13, wherein:
(i) the planarizing of the first insulating layer comprises forming a groove in the first insulating layer by over-etching the portion of the first insulating layer disposed above the first pattern; and/or
(ii) the forming of the first insulating layer comprises sequentially forming a first inorganic insulating layer and a second inorganic insulating layer containing different materials than the first inorganic insulating layer onto the lower conductive layer, and
the planarizing of the first insulating layer includes etching the second inorganic insulating layer on a portion of the first insulating layer; and/or
(iii) the method further comprises:
forming a second insulating layer on the upper conductive layer; and
forming a light-emitting element layer including a light-emitting element disposed on the second insulating layer.

15. An electronic device comprising a display device, the display device comprising:
a substrate; and
a circuit layer comprising circuit elements and wires disposed on the substrate,
wherein the circuit layer comprises:
a lower conductive layer disposed on the substrate and comprising a first pattern;
a first insulating layer disposed on the lower conductive layer, and comprising a groove disposed on a portion of the first insulating layer comprising a first portion having a reduced thickness and that is covering the first pattern;
an upper conductive layer disposed on the first insulating layer, and comprising a second pattern disposed on the groove; and
a second insulating layer covering the upper conductive layer.
